# EUROPÄISCHE PATENTSCHRIFT

(11) **EP 1 415 340 B1**
(45) Veröffentlichungstag und Bekanntmachung des Hinweises auf die Patenterteilung: **16.03.2005**
(21) Anmeldenummer: 02794499.0
(22) Anmeldetag: 02.07.2002
(51) Int. Cl.: H01L 21/8249, H01L 27/06

(54) **VERFAHREN ZUM PARALLELEN HERSTELLEN EINES MOS-TRANSISTORS UND EINES BIPOLARTRANSISTORS**
METHOD FOR THE PARALLEL PRODUCTION OF AN MOS TRANSISTOR AND A BIPOLAR TRANSISTOR
PROCEDE DE FABRICATION PARALLELE D'UN TRANSISTOR MOS ET D'UN TRANSISTOR BIPOLAIRE

(30) Priorität: 07.08.2001 DE 10138648
(43) Veröffentlichungstag der Anmeldung: 06.05.2004
(73) Patentinhaber: Infineon Technologies AG, 81669 München (DE)
(72) Erfinder: BERTHOLD, Adrian, 81925 Muenchen (DE); BOECK, Josef, 81827 Muenchen (DE); KLEIN, Wolfgang, 85604 Zorneding (DE); HOLZ, Juergen, 80804 Muenchen (DE)
(74) Vertreter: Schoppe, Fritz, Dipl.-Ing.
(86) Internationale Anmeldenummer: PCT/EP2002/007313
(87) Internationale Veröffentlichungsnummer: WO 2003/015163

(56) Entgegenhaltungen:
- EP-A- 0 746 032
- EP-A- 0 851 486
- WO-A-96/30940
- WO-A-96/30941
- US-A- 5 641 692
- PATENT ABSTRACTS OF JAPAN vol. 013, no. 051 (E-712), 6. Februar 1989 (1989-02-06) -& JP 63 244768 A (TOSHIBA CORP), 12. Oktober 1988 (1988-10-12)
- PATENT ABSTRACTS OF JAPAN vol. 2000, no. 05, 14. September 2000 (2000-09-14) -& JP 2000 040758 A (MATSUSHITA ELECTRONICS INDUSTRY CORP), 8. Februar 2000 (2000-02-08)

## Beschreibung

Die vorliegende Erfindung bezieht sich auf das Gebiet der Herstellung von Halbleiterbauelementen und spezifischer auf das Gebiet des parallelen Erzeugens mehrerer Halbleiterbauelemente.

Das parallele Erzeugen von Halbleiterbauelementen auf einem Substrat ist in der Halbleitertechnik gut bekannt. So wird beispielsweise bei einem BICMOS-Prozeß eine spezifische Abfolge von Prozeßschritten durchlaufen, um auf einem Halbleitersubstrat CMOS- und Bipolar-Transistoren zu erzeugen. Ein möglicher BICMOS-Prozeß ist beispielsweise in Widmann, Mader, Friedrich, "Technologie hochintegrierter Schaltungen", Springer Verlag, zweite Auflage, 1996 beschrieben.

Während BICMOS-Prozesse für die Herstellung von CMOS- und Bipolar-Transistoren mit geringen Integrationsdichten relativ viele Schritte in einer parallelen Verarbeitung erlauben, werden für den Herstellungsprozess für CMOS- und Bipolar-Transistoren mit hohen Integrationsdichten derzeit Verfahren verwendet, bei denen die Prozeßschritte für CMOS- und Bipolartransistoren im wesentlichen sukzessive aneinandergereiht werden. Beispielsweise werden während der Herstellung bestimmter Teile des Bipolartransistors die CMOS-Transistoren mit einer oder mehreren Schichten abgedeckt, um die Wirkung der spezifischen Prozeßschritte lediglich auf den Bereich der CMOS-Transistoren zu begrenzen.

Durch die sukzessive Aneinanderreihung von Bipolar- und CMOS-Prozeßblöcken entsteht im Laufe des Herstellungsprozesses zwischen den Bipolar- und CMOS-Transistoren ein Streifen mit einer Breite von einigen Mikrometer aus abgeschiedenen Schichten, die eine dichtere Packung von Bipolar- und CMOS-Transistoren verhindert.

Ferner sind die CMOS- und/oder Bipolar-Transistoren einer höheren thermischen Belastung als bei einem reinen CMOS- oder Bipolar-Prozeß ausgesetzt, da dieselben zusätzlich den Prozesstemperaturen der Herstellungsschritte zum Erzeugen des anderen Bauelements ausgesetzt sind. Durch die Tendenz bei neu entwickelten Bipolar- oder CMOS-Transistoren zu immer größeren Dotierstoffgradienten, d.h. zu immer flacheren Dotierprofilen, reagieren diese Transistoren auf die zusätzliche thermische Belastung empfindlich. Ferner wird durch die thermische Belastung auf die mit einer oder mehreren Schichten abgedeckten Bauelemente eine mechanische Spannung ausgeübt, die insbesondere bei den neu entwickelten Transistoren mit einem flachen Profil zu einer Verschlechterung der Bauelemente im Vergleich zu einer Herstellung mit einem reinen Bipolar- oder CMOS-Prozeß führen kann.

Es ist daher wünschenswert, ein Verfahren zum parallelen Herstellen von Bauelementen unterschiedlichen Typs zu schaffen, das ein Herstellen der Bauelementen mit einer hohen Integrationsdichte ermöglicht und bei dem Verfahrensschritte mit einer hohen Parallelität durchgeführt werden.

Ferner ist es wünschenswert, eine thermische Belastung und eine mechanische Spannung bei einer parallelen Herstellung von Halbleiterbauelementen unterschiedlichen Typs zu reduzieren.

Die Druckschritt EP-A-746 032 offenbart ein Verfahren zum parallelen Herstellen eines MOS-und eines Bipolartransistors.

Die Aufgabe der vorliegenden Erfindung besteht darin, ein verbessertes Verfahren zum Herstellen von Halbleiterbauelementen unterschiedlichen Typs auf einem Substrat zu schaffen.

Diese Aufgabe wird durch ein Verfahren nach Anspruch 1 gelöst.

Die vorliegende Erfindung schafft ein Verfahren zum parallelen Herstellen eines MOS-Transistors mit einem MOS-Bereich eines Substrats und eines Bipolar-Transistors in einem Bipolarbereich des Substrats gemäß Anspruch 1.

Der erzeugte Bipolartransistor kann dabei sowohl ein lateraler Bipolartransistor als auch ein vertikaler Bipolartransistor sein.

Die vorliegende Erfindung basiert auf der Erkenntnis, daß bei einem parallelen Herstellen eines MOS-Transistors und eines Bipolar-Transistors eine hohe Parallelität von Herstellungsschritten dadurch erreicht wird, daß die Strukturierung der Gate-Elektrode des MOS-Transistors und eines Basis-Anschlußes des Bipolar-Transistors gleichzeitig durchgeführt wird. Ferner wird eine hohe Parallelität dadurch erreicht, daß isolierende Abstandshalterschichten auf Seitenwänden der Gate-Elektrodenschicht im MOS-Bereich und die leitfähige Schicht im Bipolar-Bereich durch Aufbringen einer ersten und zweiten Abstandsschicht gleichzeitig erzeugt werden. Die isolierenden Abstandsschichten dienen im MOS-Bereich zur Definition von zu dotierenden Bereichen und im Bipolarbereich zur Isolation eines Basisbereichs und eines Emitterbereichs, wobei durch das Vorsehen der ersten und zweiten Abstandsschicht ein selektives Ätzen der ersten Abstandsschicht und der zweiten Abstandsschicht in dem MOS-Bereich und Bipolarbereich durchgeführt werden kann.

Ein Vorteil der vorliegenden Erfindung besteht darin, daß eine thermische und mechanische Belastung der MOS-Transistoren und der Bipolar-Transistoren verringert ist.

Ein weiterer Vorteil der vorliegenden Erfindung besteht darin, daß die MOS-Transistoren und die Bipolar-Transistoren mit einem geringen Flächenverbrauch pro Transistor hergestellt werden können.

Bei einem bevorzugten Ausführungsbeispiel der vorliegenden Erfindung wird ein Substrat derart vorbereitet, daß dasselbe einen MOS-Bereich und einen Bipolarbereich aufweist, wobei der MOS-Bereich auf einer Gate-Dielektrikumschicht, die auf dem Substrat aufgebracht ist, eine erste Gateelektrodenschicht und eine auf der ersten Gateelektrodenschicht aufgebrachte leitfähige Schicht als eine zweite Gatelektrodenschicht aufweist. Ferner weist der Bipolarbereich des Substrats nach der Vorbereitung eine hochleitfähige Schicht auf dem Substrat auf, die zusammen mit der leitfähigen Schicht aufgebracht wurde.

Auf die leitfähige und hochleitfähige Schicht der vorbereiteten Struktur wird ganzflächig eine Maskenschicht aufgebracht. Daraufhin wird mittels einer Photolackmaske ein Ätzen durchgeführt. Die vorbereitete Struktur weist in dem Gate-Bereich des MOS-Bereichs und einem Basis-Anschlußbereich ähnliche Schichtfolgen auf, was durch ein Ätzen ein gleichzeitiges Strukturieren sowohl der Struktur der Gateelektrode als auch eines Basisanschlußbereich des Bipolartransistors ermöglicht, wodurch das Vorsehen von ungewünschten Abdeckschichten über den Bauteilen vermieden wird. Der Basisanschlußbereich wird dabei derart strukturiert, daß ein Fenster zum Dotieren eines Kollektor-, und Basisbereichs und zum Aufbringen eines Emitterbereichs erzeugt wird. Die Dotierung der Source-, Drainund Gatebereiche des MOS-Transistors erfolgt nach einer Dotierung der Kollektor- und Basis-Bereiche des Bipolartransistors, wodurch in dem MOS-Bereich ein Eindringen des Dotierstoff und eine damit verbundene Verschlechterung des MOS-Transistors vermieden wird und das erfindungsgemäße Verfahren zur Herstellung von temperaturempfindlichen Bauteilen geeignet ist.

Ferner wird eine Schicht aufgebracht, die sowohl zur Bildung eines Abstandhalters zum Definieren gewünschter Dotierbereiche der Source- und Drain-Bereiche des MOS-Transistors als auch zur Isolierung des Emitters gegen den Basisanschlußbereich dient.

Vorzugsweise können unter Verwendung der erfindungsgemäßen Verfahrensschritte weitere Bauelemente, wie beispielsweise Varaktordioden oder MOS-Kondensatoren, in dem Substrat erzeugt werden.

Weiterbildungen der vorliegenden Erfindung sind in den abhängigen Ansprüchen dargelegt.

Nachfolgend werden unter Bezugnahme auf die beiliegenden Zeichnungen bevorzugte Ausführungsbeispiele der vorliegenden Erfindung näher erläutert. Es zeigen:

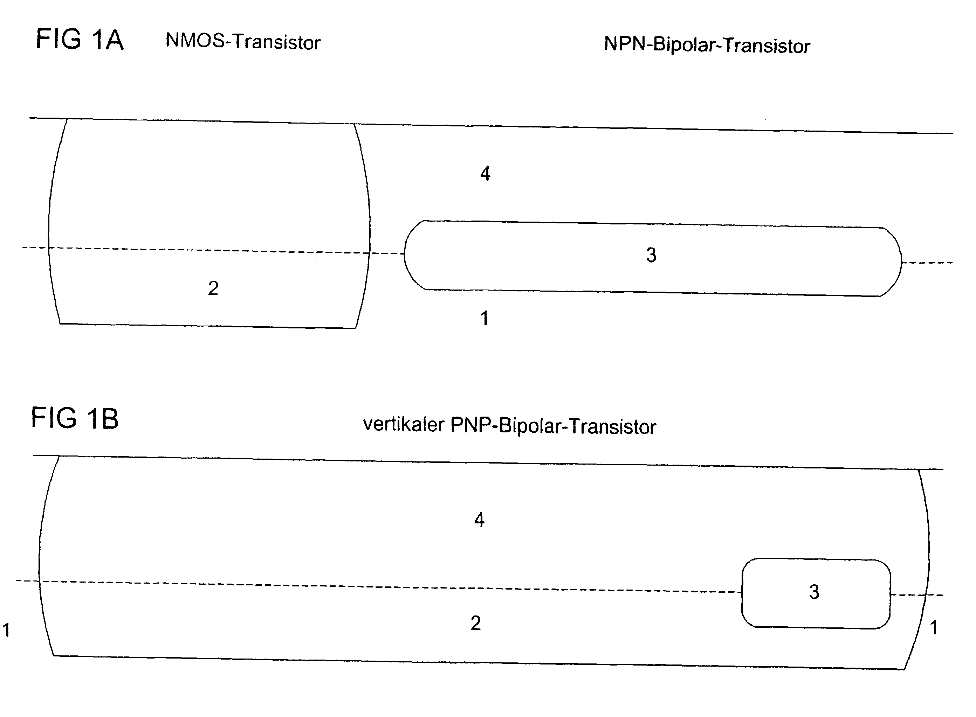

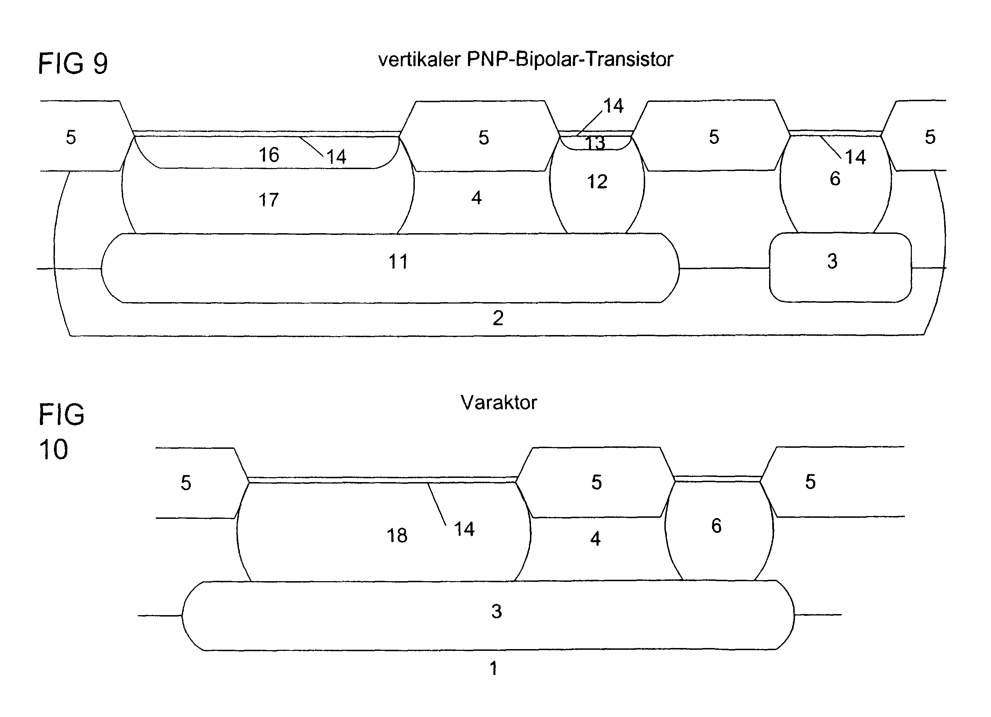

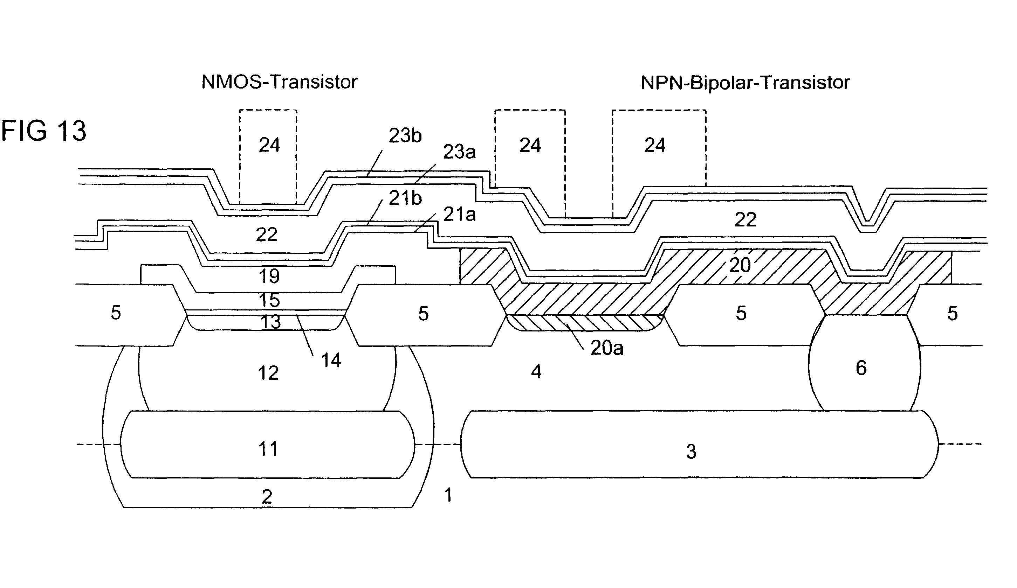

Fig. 1 bis 26 schematische Querschnittansichten, die eine Prozeßabfolge eines bevorzugten Ausführungsbeispiels der vorliegenden Erfindung darstellen.

Das nachfolgend beschriebene bevorzugte Ausführungsbeispiel der vorliegenden Erfindung stellt einen Verfahrensprozess zur parallelen Herstellung eines NMOS-Transistors, eines PMOS-Transistors, eines NPN-Bipolartransistors und eines vertikalen PNP-Transistors in einem Substrat dar. Ferner werden parallel eine MOS-Kapazität und ein Varaktor in dem Substrat 1 erzeugt. In den verschiedenen Figuren sind dabei gleichartige Elemente und Bereiche in dem Substrat jeweils durch gleiche Bezugszeichen gekennzeichnet.

In einem ersten Herstellungsschritt wird in Bereichen eines schwach p-dotierten Substrats 1, in denen die MOS-Transistoren oder vertikale PNP-Bipolartransistoren erzeugt werden sollen, ein Wannenbereich 2 mit einer n-Dotierung erzeugt. Das Substrat 1 besteht aus p-dotiertem Silizium mit einer Akzeptor-Konzentration von etwa 10¹⁵ cm⁻³. Der Wannenbereich 2 wird mit einer Donatorkonzentration von etwa 5x10¹⁶cm⁻³ durch eine Implantation und einem anschließenden Ausheilen des Dotierstoffes erzeugt. Die Diffusion des Dotierstoffes kann dabei durch ein Tempern in O₂-haltiger Atmosphäre beschleunigt werden.

Ferner wird eine niederohmige n-dotierte vergrabene Schicht 3 in dem Substrat in einer Tiefe von etwa 0,5 µm erzeugt, die bei dem fertig prozessierten Halbleiter als eine Anschlußschicht für eine untere Elektrode einer MOS-Kapazität und einer Kathode eines Varaktors, für den Anschluß eines Kollektors eines NPN-Bipolartransistors und für den Basisanschluß eines lateralen PNP-Bipolartransistors vorgesehen ist.

Die vergrabene Schicht 3 wird bei dem beschriebenen Ausführungsbeispiel durch eine oberflächennahe Implantation des Dotierstoffes und einem anschließenden epitaktischen Aufbringen einer Epitaxieschicht 4 auf dem Substrat 1 erzeugt. Alternativ kann die vergrabene Schicht 3 bei einem anderen Ausführungsbeispiel durch eine Implantation von Donator-Ionen mit einer Energie von einigen 100 bis 1000 keV und einem anschließenden Ausheilen der Implantationsdefekte erfolgen.

Fig. 1a und 1b zeigen Bereiche des Substrats 1 nach dem Erzeugen der Wanne 2 und der vergrabenen Schicht 3.

Fig 1a zeigt einen MOS-Bereich und einen Bipolarbereich des Substrats, wobei in dem MOS-Bereich die Wanne 2 mit einer Donator-Konzentration von etwa 5 x 10¹⁶ cm⁻³ ausgebildet ist und sich von der Oberfläche der auf dem Substrat 1 aufgebrachten Epitaxie-Schicht 4 mit einer Tiefe von einigen Mikrometern in das Substrat 1 erstreckt. Ferner ist in dem Bipolarbereich eine längliche vergrabene Schicht 3 gebildet, die sich entlang der Grenzfläche der Epitaxieschicht 4 und des Substrats 1 erstreckt und keine Verbindung zu der Oberfläche der Epitaxieschicht aufweist.

Während Fig. 1a eine Grundstruktur zeigt, bei der ein NMOS-Transistor in dem MOS-Bereich erzeugt wird und ein NPN-Bipolartransistor in dem Bipolarbereich erzeugt wird, weist Fig. 1b einen V-PNP-Bereich auf, in dem ein vertikaler PNP-Bipolar-Transistor erzeugt wird. Gemäß Fig. 1b ist in dem V-PNP-Bereich eine vergrabene Schicht 3 gebildet, die für einen Masseanschluß des Substrats in dem V-PNP-Bereich dient.

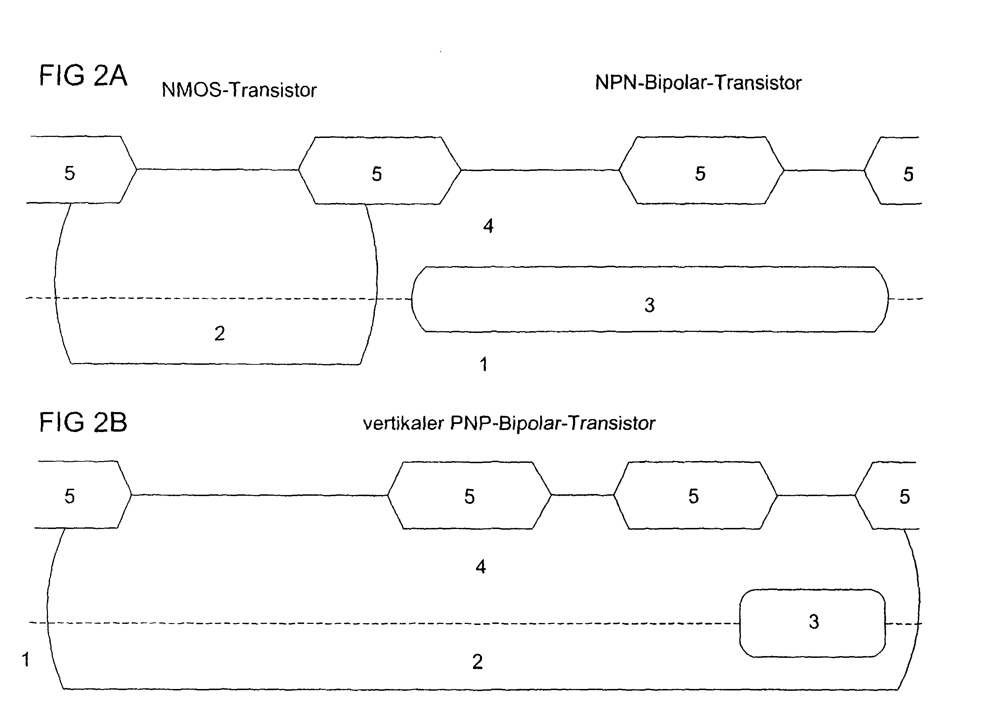

Fig. 2a zeigt die in Fig. 1a dargestellten Bereiche nach dem Durchführen eines Isolationsverfahrens. Bei diesem Isolationsverfahren werden oberflächennahe Isolationsbereiche 5 aus Siliziumoxid erzeugt, die eine elektrische Isolierung der Bauelemente und der Anschlüsse der Bauelemente gegeneinander sicherstellen. Zur Erzeugung der Isolationsbereiche 5 wird vorzugsweise ein LOCOS-Verfahren (Local Oxidation of Silicon-Verfahren = Verfahren einer lokalen Oxidation von Silizium) oder ein STI-Verfahren (Shallow Trench Isolation-Verfahren = Flach-Graben-Isolation-Verfahren) angewendet. Fig. 2b zeigt den in Fig. 1b gezeigten Vertikal-PNP-Bereich (V-PNP-Bereich) nach dem Erzeugen der in der Epitaxieschicht 4 angeordneten oberflächennahen Isolationsbereiche 5.

Zusätzlich kann bei einem Ausführungsbeispiel die Isolation der Bauelemente durch ein Deep-Trench-Isolation-Verfahren (Tief-Graben-Isolation-Verfahren) erreicht werden, was zur Erreichung einer weiteren Flächenreduktion beiträgt.

Zum Anschluß der vergrabenen Schicht 3 wird in einem nachfolgenden Prozeßschritt eine niederohmige n-dotierte Verbindungswanne 6 erzeugt. Vorzugsweise erfolgt die Erzeugung der Verbindungswanne 6 durch eine Implantation von Donator-Ionen und einer anschließenden Diffusion des Dotierstoffs.

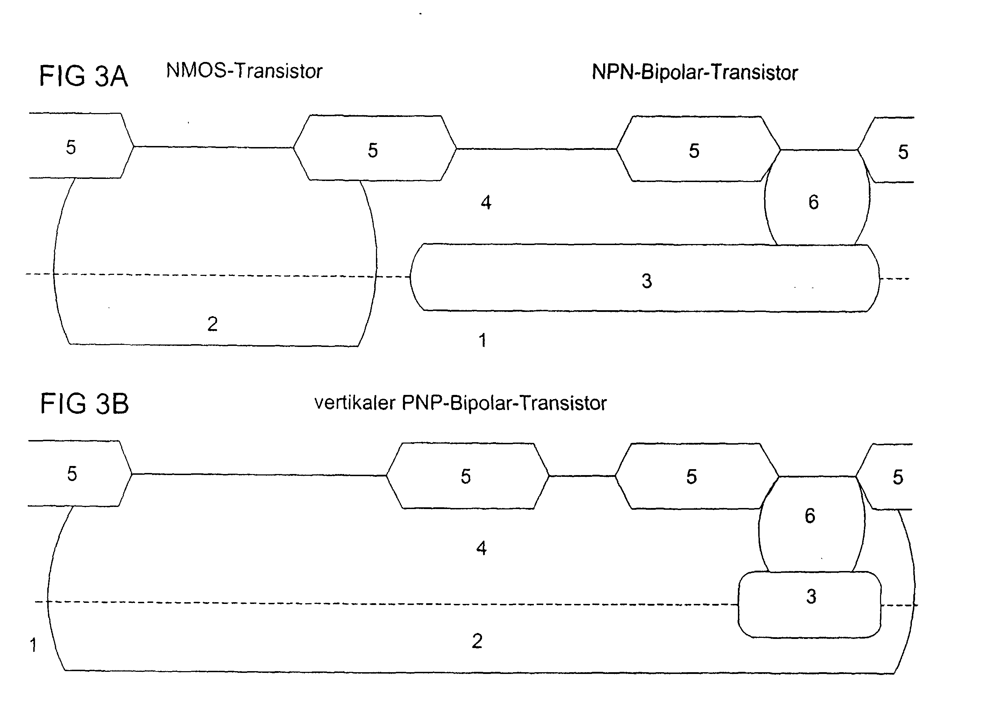

Fig. 3a zeigt den in Fig. 2a gezeigten MOS-Bereich und Bipolar-Bereich nach dem Erzeugen der niederohmigen Verbindungswanne 6. Die Verbindungswanne 6 erstreckt sich in einem Bereich zwischen zwei Isolationsbereichen 5 von der Oberfläche der Epitaxieschicht 4 zu der vergrabenen Schicht 3.

Fig. 3b zeigt den in Fig. 2b gezeigten Bereich ebenfalls nach der Erzeugung der Verbindungswanne 6, wobei sich entsprechend zu Fig. 3a die Verbindungswanne 6 in einem Bereich zwischen zwei Isolationsbereichen 5 von der Oberfläche der Epitaxieschicht 4 vertikal zu der vergrabenen Schicht 3 erstreckt.

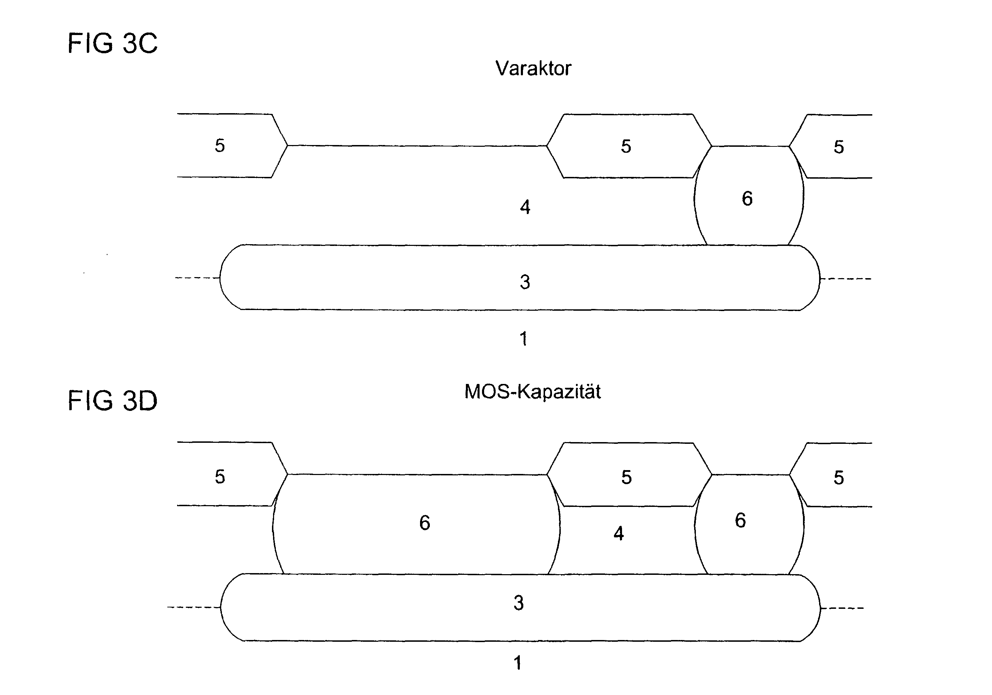

Fig. 3c zeigt einen Varaktorbereich und Fig. 3d zeigt einen Kapazitätsbereich nach dem Durchlaufen der obig beschriebenen Herstellungsschritte. Fig. 3c weist dabei das Substrat 1 mit der darüber aufgebrachten Epitaxieschicht 4 sowie eine längliche vergrabene Schicht 3 auf, wobei die längliche vergrabene Schicht 3 an die Verbindungswanne 6 angeschlossen ist, um eine elektrische Verbindung mit der Oberfläche zu liefern. Ferner sind mehrere Isolationsbereiche 5 auf der Oberfläche der Epitaxieschicht 4 gebildet.

Fig. 3d zeigt einen Bereich zur Herstellung einer MOS-Kapazität, bei dem eine längliche verborgene Schicht 3 über zwei Verbindungswannen 6 mit Oberflächenbereichen der Epitaxieschicht, die durch die Isolationsbereiche 5 voneinander isoliert sind, verbunden ist.

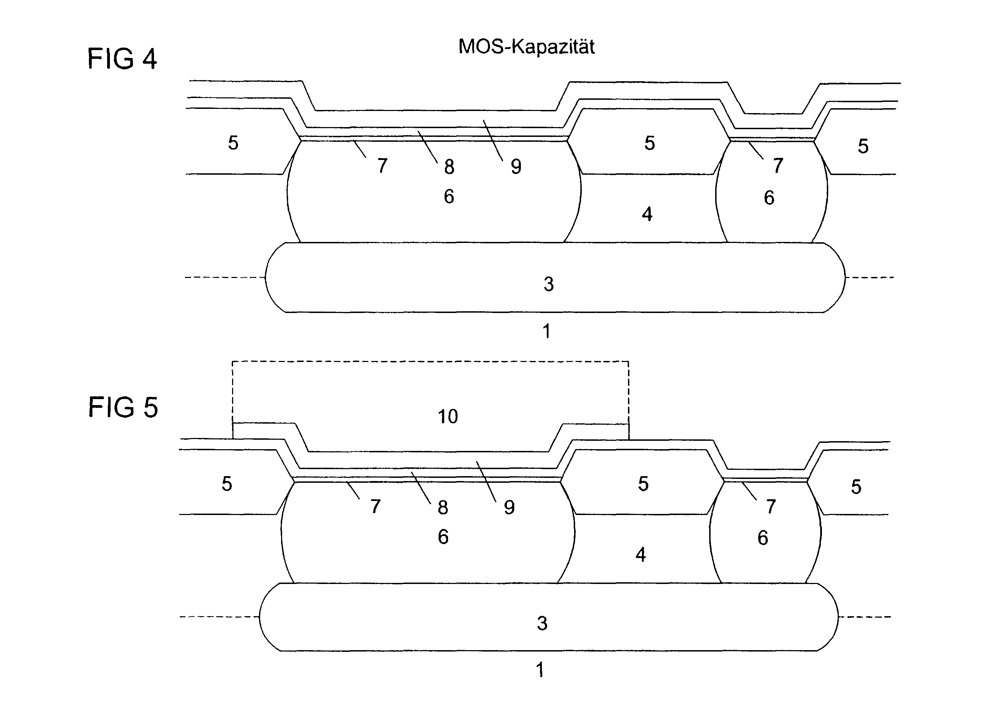

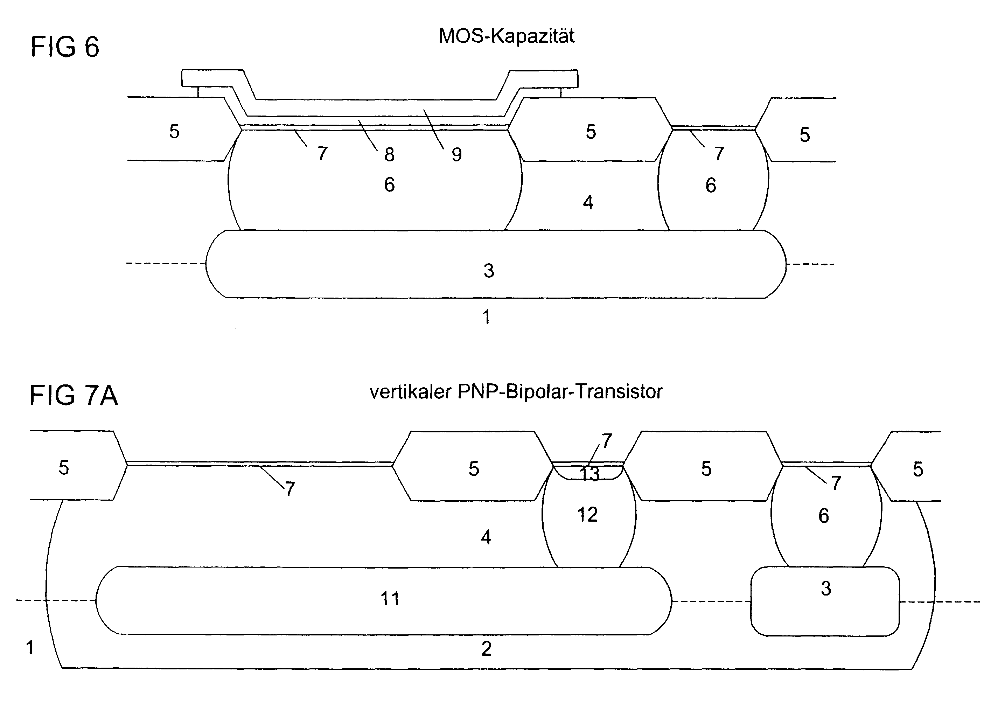

Fig. 4 zeigt den Kapazitätsbereich nach dem Erzeugen einer Oxidschicht 7 und einer Nitridschicht 8 in dem Bereich der Verbindungswannen 6, wobei die Oxidschicht 7 und Nitridschicht 8 als eine Dielektrikumschicht für die MOS-Kapazität dienen. Zuerst wird die Oxidschicht 7 ganzflächig auf der Oberfläche der Epitaxieschicht 4 als eine dünne Schicht mit einer Dicke von wenigen nm aus einem thermischen Oxid gebildet. Darüber wird eine dünne Nitridschicht 8 mit einer Dicke von wenigen 10 nm abgeschieden, wobei sich die Nitridschicht 8 ganzflächig erstreckt. Ebenso wird eine leitfähige Schicht 9 vorzugsweise als Polysiliziumschicht ganzflächig auf der Nitridschicht 8 abgeschieden und in einem darauffolgenden Strukturierungsprozeß mittels einer Photolackmaske 10 und einem RIE-Ätzschritt (RIE = Reactive Ion Etch = reaktives Ionenätzen) selektiv zu dem darunter angeordneten Nitrid geätzt, so daß sich die leitfähige Schicht 9 auf dem Bereich der Verbindungswanne 6 und teilweise auf einem Teil der an die Verbindungswanne 6 angrenzenden Isolationsbereiche erstreckt, siehe Fig. 5. Die leitfähige Schicht 9 wirkt während der nachfolgenden Herstellungsschritte als eine Schutzschicht für die Oxidschicht 7 und Nitridschicht 8. Die leitfähige Schicht 9 kann derart dotiert erzeugt werden, daß dieselbe als obere Elektrode der MOS-Kapazität dient.

Fig. 6 zeigt den in Fig. 5 gezeigten Aufbau nach einem weiteren Schritt eines Ätzens der Nitridschicht 8 selektiv zu dem Oxid und der leitfähigen Schicht der Schichten 7 und 9 und einem darauffolgenden Entfernen der Photolackmaske 10. Das auf der Oberfläche der Epitaxieschicht verbleibende Oxid der Oxidschicht 7 dient bei dem Herstellungsprozess für nachfolgende Implantationen als eine Streuschicht, um ein Channeling des Dotierstoffes im Substrat sowie eine Ausdiffusion des implantierten Dotierstoffes in die Umgebung zu unterdrücken. Die leitfähige Schicht 9 weist bei dem beschriebenen Ausführungsbeispiel eine Dicke von etwa 100 nm auf und ist aus Polysilizium gebildet, das zu einem späteren Zeitpunkt dotiert wird.

Das Dielektrikum der MOS-Kapazität, d.h. die Oxidschicht 7 und die Nitridschicht 8, kann alternativ nach der Bildung des Gate-Dielektrikums und der Gate-Elektrode abgeschieden und daraufhin strukturiert werden, wobei das MOS-Dielektrikum auch auf der Gate-Elektrode abgeschieden wird. In diesem Fall ist es nicht erforderlich, die elektrisch leitfähige Schicht 9 zu bilden, da anschließend die obere Gate-Elektrode abgeschieden wird. Nachdem die Oxidschicht 7 und die Nitridschicht abgeschieden sind, wird die Nitridschicht 8 in einem RIE-Schritt mit einer Fotomaske selektiv zu dem darunter liegenden Oxid der Oxidschicht 7 geätzt.

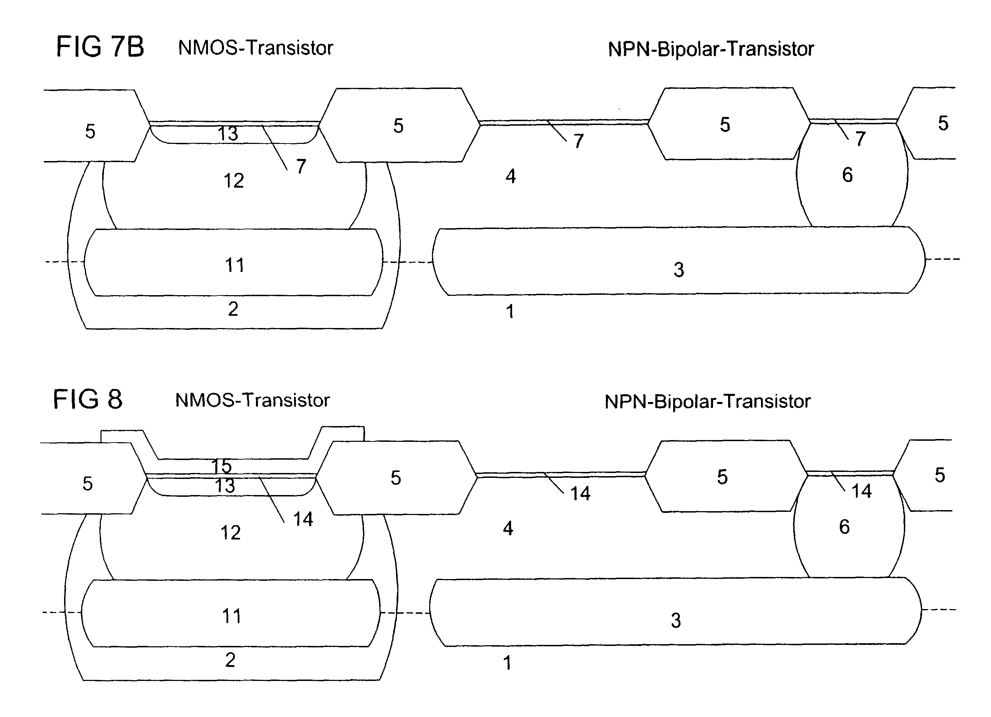

Daraufhin wird zur Bildung eines Kollektoranschlusses für den vertikalen PNP-Bipolar-Transistor eine niederohmige, p-leitende vergrabene Anschlußschicht 11, die sich in einer Tiefe von etwa 0,5 µm befindet, beispielsweise durch eine Implantation von Akzeptor-Ionen mit einer Energie von einigen 100 keV erzeugt, siehe Fig. 7a. Ebenso werden in den NMOS-Bereichen vergrabene Anschlußschichten 11 erzeugt, siehe Fig. 7b, die eine p-Dotierung aufweisen. Für den PMOS-Transistor dient die vergrabene Schicht 3 als Anschlußschicht.

In einem nächsten Schritt werden gleichzeitig ein Kollektoranschluß für den V-PNP-Transistor und eine dotierte Wanne und ein leitender Kanal für den MOS-Transistor gebildet. Dazu wird sowohl in dem V-PNP-Bereich als auch in dem MOS-Bereich durch eine oberflächennahe Implantation von Akzeptor- bzw. Donator-Ionen Wannen 12 erzeugt, die sich von der Oberfläche etwa 0,5 µm tief in das Substrat erstrecken. Ferner werden in der Nähe der Oberfläche der gebildeten Wanne 12 p-leitende bzw. n-leitende Schichten 13 durch eine weitere oberflächennahe Implantation erzeugt. Alternativ kann in dem Bereich der leitenden Schicht 13, der zur Bildung des Kanals des MOS-Transistors vorgesehen ist, eine Dotierung zur Erzeugung des leitenden Kanals auch in einem späteren Prozeßschritt erfolgen.

Die leitende Schicht 13 dient in dem V-PNP-Bereich zur Verbesserung der elektrischen Verbindung der Wanne 12 mit der Oberfläche bzw. mit den nachfolgend auf der Oberfläche aufgebrachten Schichten, während die leitende Schicht 13 in dem MOS-Bereich als eine Kanalschicht verwendet wird. Implantationsschäden, die sich bei der Implantation ergeben, werden mit einem Temperschritt ausgeheilt. Wahlweise kann als Temperschritt der nachfolgende Schritt einer Gateoxidation verwendet werden, der unten beschrieben wird.

Fig. 7a zeigt den V-PNP-Bereich nach den obig beschriebenen Verfahrensschritten. Die p-dotierte Anschlußschicht 11 erstreckt sich als längliche Schicht entlang der Grenzfläche zwischen Substrat 1 und Epitaxieschicht 4, während an der Oberfläche eines Bereichs zwischen zwei Isolationsbereichen 5 die leitende Schicht 13 ausgebildet ist, von der sich die Wanne 12 vertikal zu der Anschlußschicht 11 erstreckt, um die vergrabene Anschlußschicht 11 mit der Oberfläche zu verbinden.

Fig. 7b zeigt den MOS-Bereich und den Bipolarbereich nach der Durchführung der obig erwähnten Prozeßschritte. Wie bei dem V-PNP-Transistor ist die vergrabene Anschlußschicht 11 über die Wanne 12 in einem Bereich zwischen zwei Isolationsbereichen 5 mit der Oberfläche verbunden. Die leitende Schicht 13, die auf der Wanne 12 gebildet ist, stellt dabei die p-dotierte Kanalschicht des NMOS-Transistors dar. Wie bereits erwähnt wurde, dient die auf der Oberfläche angeordnete Oxidschicht 7 als Streuschicht bei der Implantierung von Akzeptor- bzw. Donator-Ionen der Wanne 12 und der leitenden Schicht 13. Die Dotierstoff-Konzentration der leitenden Schicht 13 bestimmt die Einsatzspannung des MOS-Transistors.

Daraufhin wird die dünne Oxidschicht 7, die als Streuschicht für die Implantationen und als Abdeckung für nachfolgende Temperschritte diente, entfernt.

Anschließend wird eine erste Dielektrikumschicht 14, die eine Dicke von einigen nm aufweisen kann und aus einem thermischen Oxid besteht, sowie eine erste Gate-Elektrodenschicht 15, die aus undotiertem Polysilizium mit einer Dicke von etwa 100 nm besteht, auf der Oberfläche abgeschieden. Die erste Gate-Elektrodenschicht 15 wird darauf in einem RIE-Schritt mit einer Photolackmaske in Bereichen der Substratoberfläche, an denen keine MOS-Transistoren gebildet werden, selektiv zu dem Oxid der Gate-Dielektrikumschicht 14 entfernt.

Fig. 8 zeigt den MOS-Bereich und den Bipolarbereich nach der Durchführung der vorhergehend erwähnten Herstellungsschritte. Der MOS-Bereich weist auf der leitenden Schicht 13 die dünne Dielektrikumschicht 14 und die erste Gate-Elektrodenschicht 15 auf. Der Bipolarbereich weist auf der Oberfläche der Epitaxieschicht 4 die Gate-Dielektrikumschicht 14 auf.

In einem nachfolgenden Schritt wird ein Basisbereich 16 und ein Kollektorbereich 17 des V-PNP-Transistors und eine Wanne 18 in dem Varaktorbereich erzeugt. Dabei wird mittels einer Photolackmaske eine Implantation von Akzeptoren bzw. Donatoren durch die Gate-Dielektrikumschicht 14 hindurch durchgeführt. Bei einer nachfolgenden Temperung werden die Implantationsdefekte ausgeheilt und eine gewünschte Dotierstoff-Verteilung sichergestellt.

Fig. 9 zeigt den V-PNP-Bereich nach der Durchführung des oben erwähnten Verfahrensschritt. Über der p-dotierten Anschlußschicht 11 ist der p-dotierte Kollektorbereich 17 in einem Wannenprofil gebildet. Ferner ist zwischen dem Kollektorbereich 17 und der Gate-Dielektrikumschicht 16 der n-dotierte Basisbereich 16 gebildet.

Fig. 10 zeigt den Varaktorbereich nach der Durchführung der oben erwähnten Verfahrensschritte. Die gebildete n-dotierte Wanne 18 erstreckt sich in vertikaler Richtung von der Gate-Dielektrikumschicht 14 zu der vergrabenen Schicht 3.

Als nachfolgender Schritt wird die Gate-Dielektrikumschicht in den Bereichen außerhalb des MOS-Transistors, selektiv zum Silizium-Substrat, beispielsweise mittels einer naßchemischen Ätzung, entfernt. Daraufhin wird eine elektrisch leitfähige Schicht 19 abgeschieden, die in dem Bipolarbereich als Basisanschluß des NPN-Transistors, in dem MOS-Bereich als obere Gate-Elektrode, in dem V-PNP-Bereich als ein Emitter- und Kollektor-Anschluß, in dem Kapazitätsbereich als obere Elektrode der MOS-Kapazität und in dem Varaktorbereich als obere Elektrode dient.

Die leitfähige Schicht 19 weist bei dem beschriebenen Ausführungsbeispiel eine Silizium-Schicht mit einer Dicke von etwa 200 nm auf, die als amorphe Schicht abgeschieden wird. Die Leitfähigkeit der leitfähigen Schicht 19 wird durch eine nachfolgende Dotierstoffimplantation und darauffolgende Ausheilschritte erreicht. Dabei wird in den Bereichen mit einem Kontakt der leitfähigen Schicht 19 mit der Epitaxieschicht 4 in derselben ein Dotierstoff-Profil erzeugt, das eine Tiefe von lediglich einigen 10 nm aufweist.

In dem Bipolarbereich und in Bereichen, die für einen niederohmigen Widerstand vorgesehen sind, wird die leitfähige Schicht 19 zusätzlich hoch p-dotiert, um eine hochleitfähige Schicht 20 zu erhalten. Die Erzeugung der hochleitfähigen Schicht 20 aus der leitfähigen Schicht 19 erfolgt beispielsweise durch eine Verwendung einer Photolackmaske in Verbindung mit einer darauffolgenden Implantation von Akzeptor-Ionen. Ein hochohmiger Widerstand kann aus der leitfähigen Schicht 19 mit leitfähigen Bereichen aus der hochleitfähigen Schicht 20 für die Anschlüsse bestehen.

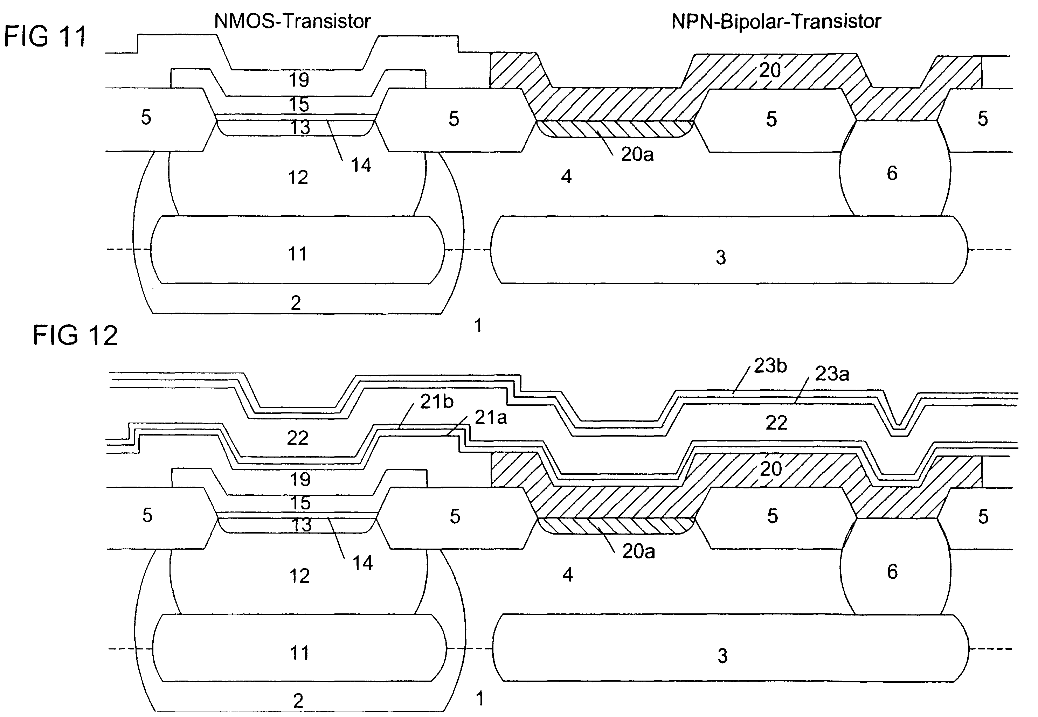

Fig. 11 zeigt den MOS-Bereich und den Bipolarbereich in dem Zustand nach der Durchführung der oben beschriebenen Herstellungsschritte. Dabei weist der MOS-Bereich die leitfähige Schicht 19 über der ersten Gate-Elektrodenschicht 15 auf, während in dem Bipolarbereich die hochleitfähige Schicht 20 auf der Oberfläche angeordnet ist. Der Dotierstoff der hochleitfähigen Schicht 20 wird während folgender Prozeßschritte durch die auftretende hohe thermische Belastung nachfolgender Temperschritte und Schichtabscheidungen in vertikaler Richtung verteilt und im Siliziumgitter eingebaut, so daß der Dotierstoff dort elektrisch aktiv ist. Fig. 11 zeigt ferner den durch Diffusion des Dotierstoffs aus dem Bereich der hochleitfähigen Schicht 20 entstandenen p-leitenden Bereich 20a über der Epitaxieschicht 4. In dem Bereich der Verbindungswanne 6 wird dagegen kein p-leitender Bereich gebildet, da in diesem Bereich die Donator-Konzentration größer als die durch Diffusion aus der hochleitenden Schicht 20 hervorgehende Akzeptor-Konzentration ist. Die Diffussion aus der hochleitenden Schicht 20 findet nur solange statt bis diese im Bereich der Verbindungswanne entfernt wird.

Um eine weitere Diffusion der Akzeptor-Ionen der Diffusionsschicht 20a in die Epitaxieschicht 4 bzw. das Siliziumsubstrat 1 zu minimieren, kann die Dotierung der hochleitfähigen Schicht 20 alternativ nach der Bildung einer ersten Isolationsschicht 21a erfolgen, die nachfolgend beschreibenden wird.

Als nächster Schritt wird zumindest eine Isolationsschicht, die auch als Maskenschicht dient, abgeschieden. Bei dem bevorzugten Ausführungsbeispiel ist eine Isolationsschichtfolge, die auch als Maskenschichtfolge bezeichnet werden kann, aus einer ersten Isolationsschicht, die eine aus Tetra-Ethyl-Ortho-Silikat (TEOS) abgeschiedene TEOS-Isolationsschicht 21a und eine Nitrid-Isolationsschicht 21b aus Nitridmaterial aufweist, und einer zweiten TEOS-Isolationsschicht 22 gebildet. Bei einem alternativen Ausführungsbeispiel kann die Isolationsschicht 21 aus einer einzigen Schicht gebildet sein. Die TEOS-Isolationsschicht 21a und die Nitrid-Isolationsschicht 21b weisen jeweils eine Dicke von etwa 20 nm auf, während die zweite Isolationsschicht 22 eine Dicke von etwa 200 nm aufweist. Die Isolationsschicht bzw. Isolationsschichtfolge dient in dem Bipolarbereich dazu, die hochleitfähige Schicht 20, die einen Basisanschluß darstellt, und eine noch aufzubringende Emitteranschlußschicht 33, die aus Polysilizium mit einer hohen n-Dotierung besteht, elektrisch zu isolieren. In dem MOS-Bereich dient die Isolationsschichtfolge als eine Hartmaske für eine folgende anisotrope Ätzung des Gate-Siliziums, das durch die erste Gate-Elektrodenschicht 15 und die leitfähige Schicht 19 gebildet wird, und ferner als eine Diffusionsbarriere für eine anschließende Temperung nach Dotierung des Gatesiliziums.

Fig. 12 zeigt den MOS-Bereich und den Bipolarbereich nach dem Abscheiden der Isolationsschichtfolge. Dabei ist die TEOS-Isolationsschicht 21a ganzflächig auf der leitfähigen Schicht 19 bzw. der hochleitfähigen Schicht 20 angeordnet. Weiters ist in Fig. 12 die auf der TEOS-Isolationsschicht 21a aufgebrachte Nitrid-Isolationsschicht 21b und die darüber angeordnete zweite Isolationsschicht 22 gezeigt.

Die Verwendung und Funktionen der Isolationsschichtfolge werden nun nachfolgend erklärt.

Die Isolationsschichtfolge, die bei dem beschriebenen Ausführungsbeispiel aus den Isolationsschichten 21a, 21b und 22 besteht, muß in dem vorhergehend beschriebenen Schritt mit einer Dicke von etwa 200 nm aufgebracht werden, da dieselbe in dem Bipolarbereich verwendet wird, um eine gute Isolation zwischen der hochleitfähigen Schicht 20 und einer später aufgebrachten Emitterschicht 33 sicherzustellen und eine störende parasitäre Kapazität, die sich durch die hochleitfähige Schicht 20, die Isolationsschichtfolge und die Emitterschicht 33 ergibt, zu verhindern und ferner eine ausreichend hohe Ätzflanke bei der Erzeugung eines Abstandhalters ermöglichen, wie es nachfolgend beschrieben wird.

Die zweite Isolationsschicht 22 wird in dem MOS-Bereich in einem nachfolgenden Schritt mittels einer naßchemischen oder trockenen Ätzung geätzt, so daß in dem Gate-Bereich eine entsprechende Dünnheit der Isolationsschicht erreicht wird, die es ermöglicht, eine hohe p- bzw. n-Dotierung der Gateelektrode durch eine oberflächennahe Implantation durchzuführen. Dabei muß für die Gate-Dotierung eine oberflächennahe Ionen-Implantation verwendet werden, da im Gatebereich ein Dotieren des darunterliegenden Siliziumsubstrats vermieden werden soll und gleichzeitig mit der Gateelektrode die oberflächennahen Source- und Drainbereiche in der leitenden Schicht 13 dotiert werden sollen. Dazu ist eine Dicke der Isolationsschicht in dem Gatebereich von einigen 10 nm erforderlich.

Um diese Dünnung der Isolationsschicht auf eine kontrollierte Weise zu erreichen, wird bei dem Ausführungsbeispiel eine Isolationsschichtfolge aus der ersten Isolationsschicht 21a, 21b und der zweiten Isolationsschicht 22 verwendet, wobei die zweite Isolationsschicht 22 mit einer Dicke von etwa 200 nm selektiv zu der darunterliegenden ersten Isolationsschicht ätzbar ist.

Bei dem beschriebenen Ausführungsbeispiel umfaßt die erste Isolationsschicht zwei Schichten, d.h. die TEOS-Isolationsschicht 21a und die Nitrid-Isolationsschicht 21b, wobei der Grund für die Verwendung der Schichten nachfolgend erklärt wird.

Vor der Dotierung der Gateelektrode wird in dem Bereich der Gateelektrode eine Ätzung zur Strukturierung der Gateelektrode durchgeführt, wobei die nach der Ätzung der zweiten Isolationsschicht verbleibende erste Isolationsschicht über der Gateelektrode als eine Hartmaske verwendet wird, um eine Ätzung der Gateelektrode zu vermeiden. Verwendet man eine einzige erste Isolationsschicht, so muß die Schicht die Anforderungen eines Ätzstopps für die Ätzung der zweiten Isolationsschicht 22 und einer Hartmaske für die Strukturierungsätzung der Gateelektrode erfüllen. Steht dabei für die erste Isolationsschicht kein geeignetes Material zur Verfügung, so kann die erste Isolationsschicht aus mehreren Schichten bestehen, beispielsweise gemäß dem beschriebenen Ausführungsbeispiel aus der TEOS-Isolationsschicht 21a und Nitrid-Isolationsschicht 21b. Dabei erfüllt die Nitrid-Isolationsschicht 21b die Anforderung eines Ätzstopps für die Ätzung der zweiten Isolationsschicht 22 während die TEOS-Isolationsschicht 21a einen Ätzstopp und somit eine Hartmaske für die Strukturierungsätzung der Gateelektrode darstellt, bei der die Nitrid-Isolationsschicht 21b entfernt wird.

Alternativ kann anstatt einer Isolationsschichtfolge auch eine einzige Isolationsschicht als Maskenschicht verwendet werden, wobei die Dünnung derselben durch einen anisotropen RIE-Ätzschritt mit einer fest eingestellten Ätzzeit erfolgt.

Die Verwendung mehrerer Isolationsschichten mit unterschiedlichen Materialien als Maskenschicht weist jedoch den Vorteil einer größeren Steuerbarkeit auf, da durch eine geeignete Materialauswahl eine selektive Ätzung erreicht werden kann, so daß bei einer naßchemischen Ätzung oder Trockenätzung eine darunterliegende Schicht als Ätzstopp wirkt, wodurch das Erzeugen von Schichten mit einer definierten Schichtdicke ermöglicht ist.

Ferner ist auf der zweiten Isolationsschicht 22 eine ARC-Schicht (Anti-Reflective-Coating-Schicht = Anti-Reflexions-Abdeckschicht) gezeigt, die aus einer Siliziumschicht aus amorphem Silizium mit einer Dicke von etwa 40 nm und einer Siliziumnitrid-Schicht 23b mit einer Dicke von etwa 35 nm besteht. Die ARC-Schicht wird vorzugsweise durch ein Sputtern gebildet und dient zur Verbesserung der Strukturierung der nachfolgend erzeugten Gate-Elektrodenstruktur und eines Fensterbereichs in der hochleitfähigen Schicht 20 des Bipolarbereichs. Zur Strukturierung der Gate-Elektrode, eines Fensterbereichs in dem Bipolarbereich und eines Emitter/Kollektoranschlußbereichs in dem V-PNP-Bereich wird ein Photolack aufgebracht und belichtet. Die gebildete Photolackstruktur 24 weist in dem Bipolarbereich eine Ausnehmung auf, die den Bereich zum Bilden eines Fensters in der hochleitfähigen Schicht 20 definiert. Daraufhin wird die ARC-Schicht 23a und 23b, die zweite Isolationsschicht 22, die Nitrid-Isolationsschicht 21b und die TEOS-Isolationsschicht 21a in einem anisotropen RIE-Ätzschritt in den Bereichen, die nicht von dem Photolack 24 bedeckt sind, entfernt, um die Gate-Elektrode, das Fenster in dem Bipolarbereich und der Emitter/Kollektoranschlußbereich in dem V-PNP-Bereich zu strukturieren. Zur Entfernung können dabei mehrere RIE-Schritte verwendet werden, wobei der letzte RIE-Schritt selektiv zu dem Polysiliziummaterial der leitfähigen Schicht 19 bzw. der hochleitfähigen Schicht 20 ist.

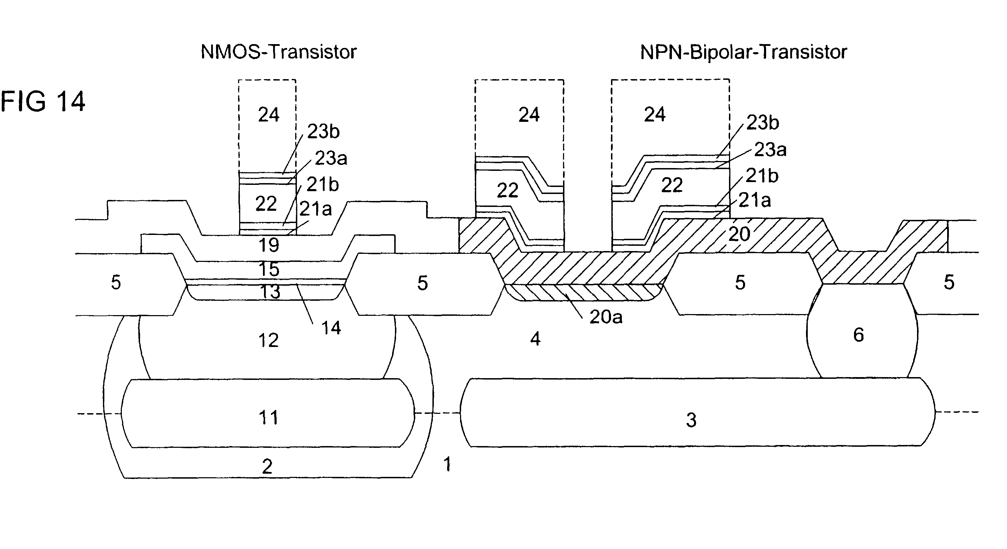

Fig. 14 zeigt den MOS-Bereich und den Bipolarbereich nach dem Ätzen der Isolationsschichten 21a, 21b und 22 und der ARC-Schicht 23a und 23b. Dabei weist der Bereich, in dem die Gate-Elektrode gebildet werden soll, über der leitfähigen Schicht 19 die durch Photolithographie strukturierte Isolationsschicht mit den Schichten 21a, 21b, 22 sowie die darüber angeordneten ARC-Schichten 23a und 23b. Auf der ARC-Schicht 23b ist ferner ein Steg des Photolacks 24 gezeigt, der als eine Maske bei der Ätzung diente. In dem Bipolarbereich ist ferner durch das RIE-Ätzen und die durch den Photolack 24 gebildete Maske in den übereinander aufgebrachten Schichten 21a, 21b, 22, 23a und 23b eine Ausnehmung gebildet. In einem nachfolgenden Schritt werden der Photolack 24 und Polymere, die durch die Ätzung entstehen, entfernt.

In einem weiteren anisotropen RIE-Schritt werden durch ein Ätzen von Oxiden und Nitriden selektiv zu Polysilizium Reste der Isolationsschichten 21a, 21b und 22 an Topographiestufen und das Siliziumnitrid der ARC-Schicht 23b entfernt.

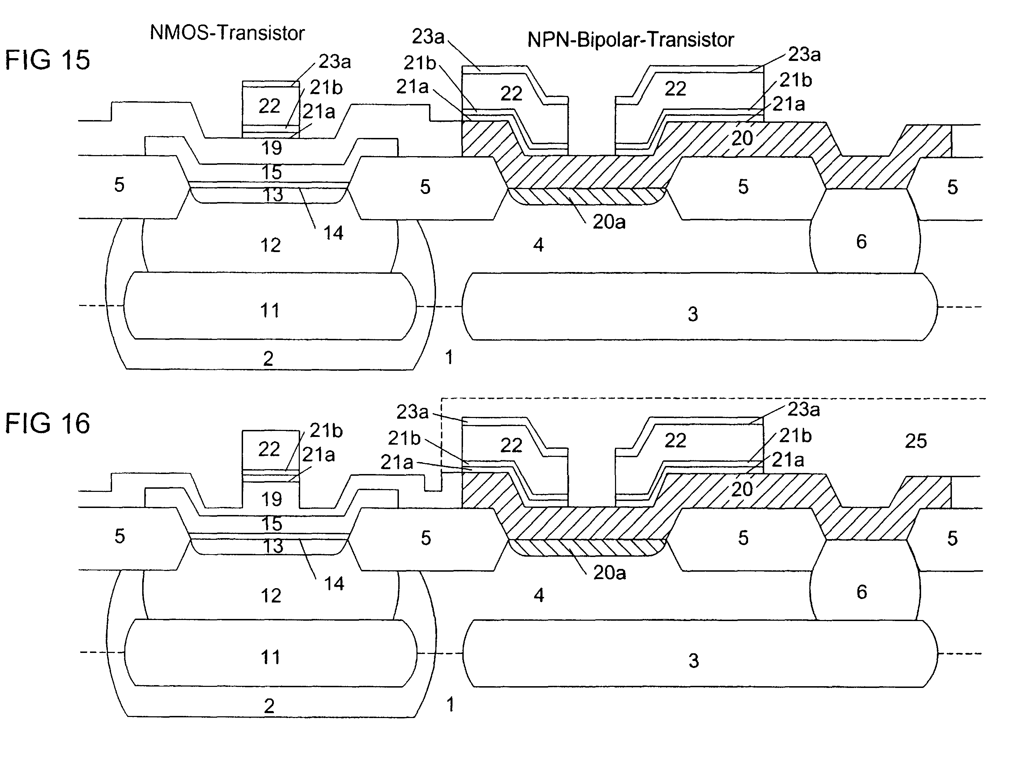

Der Verfahrenszustand nach der Durchführung der Ätzschritte ist für den MOS-Bereich und den Bipolarbereich in Fig. 15 gezeigt.

Anschließend wird eine Dünnung der leitfähigen Schicht 19 in dem MOS-Bereich mittels einer anisotropen Ätzung durchgeführt. Um die Ätzung lediglich auf die leitfähige Schicht 19 in dem MOS-Bereich zu beschränken, wird in dem Bipolarbereich eine Photolackmaske 25 als Schutzmaske aufgebracht. Gleichzeitig mit der Dünnung der leitfähigen Schicht 19 wird das amorphe Silizium der verbliebenen ARC-Schicht 23a entfernt, wodurch die zweite Isolationsschicht 22 freigelegt wird.

Die Dünnung der leitfähigen Schicht 19 ist erforderlich, um eine nachfolgende Ätzung der leitfähigen Schicht 19 und der ersten Gate-Elektrodenschicht 15 zusammen mit einer Ätzung der hochleitfähigen Schicht 20 ohne verbleibende Reste an Topographie-Stufen zu ermöglichen. Nach der Durchführung der Dünnung beträgt die Restdicke der gedünnten leitfähigen Schicht 19 etwa 150 nm.

Fig. 16 zeigt die Struktur von Fig. 15 nach dem Durchführen der Dünnung der leitfähigen Schicht 19. Ferner ist die Oberfläche der strukturierten zweiten Isolationsschicht 22 durch die Entfernung der ARC-Schicht 23a freigelegt. In dem Bipolarbereich ist ferner der Photolack 25 als eine ganzflächig angeordnete Schutzmaske gezeigt.

In einem anschließenden Verfahrensschritt wird die zweite Isolationsschicht 22 in dem MOS-Bereich entfernt, wobei der Photolack 25 in dem Bipolarbereich wiederum sicherstellt, daß die Ätzung lediglich auf den MOS-Bereich begrenzt ist.

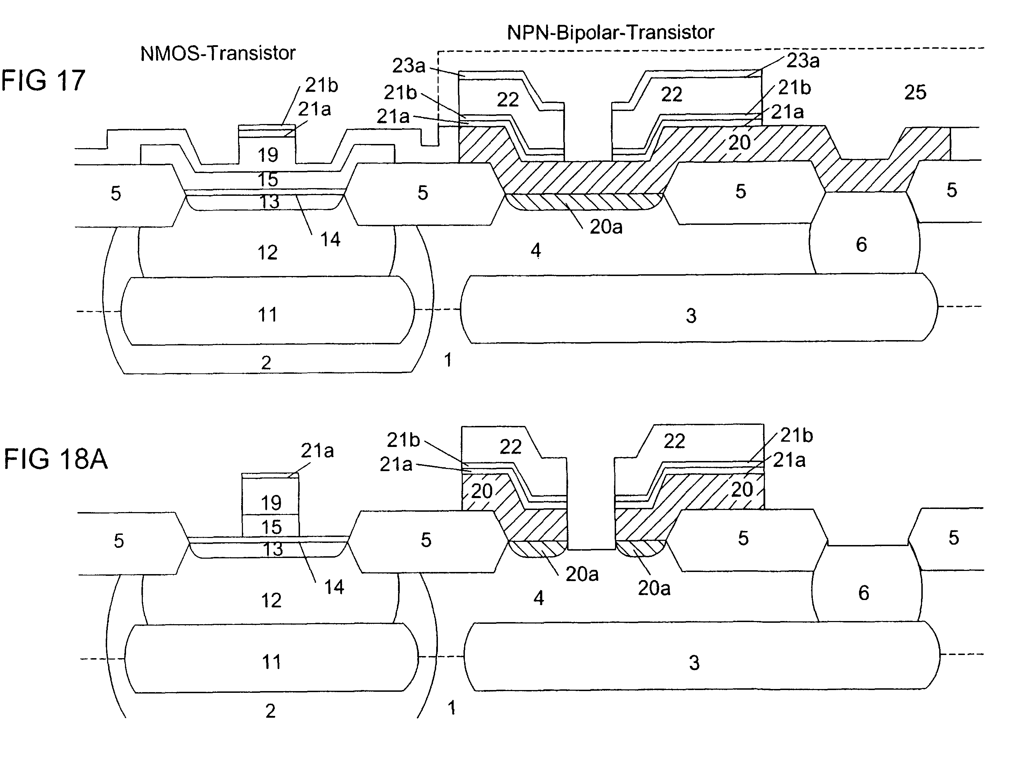

Fig. 17 zeigt den MOS-Bereich und den Bipolarbereich nach dem Entfernen der zweiten Isolationsschicht 22 in dem MOS-Bereich.

Wie unter Bezugnahme auf Fig. 12 bereits vorhergehend erklärt wurde, wird das Entfernen der zweiten Isolationsschicht 22 durchgeführt, um für die folgende Dotierung der Gate-Elektrode mittels einer oberflächennahen Ionen-Implantation in dem Gate-Bereich eine dünne Schicht von einigen 10 nm bereitzustellen, die ein Hängenbleiben des Dotierstoffes in den Isolationsschichten vermeidet.

Die gleichzeitige Dotierung der Gate-, Source- und Drainbereiche stellt eine zusätzliche Einsparung von Herstellungsschritten dar und erhöht die Parallelität des Verfahrens.

Bei dem beschriebenen Ausführungsbeispiel ist die Isolationsschichtfolge aus der ersten Isolationsschicht, die die Nitrid-Isolationsschicht 21b und die TEOS-Isolationsschicht 21a umfaßt, und der zweiten Isolationsschicht 22 gebildet. Die erste Isolationsschicht erfüllt die Funktion einer Stoppschicht für die Ätzung der zweiten Isolationsschicht. Die Nitrid-Isolationsschicht 21b wird bei der folgenden Stukturierungsätzung geätzt, so daß nach der Strukturierung der Gateelektrode die TEOS-Isolationsschicht 21a auf derselben verbleibt. Die TEOS-Isolationsschicht 21a ist ferner bezüglich einer Schichtdicke, die bei dem beschriebenen Ausführungsbeispiel 20nm beträgt, derart gewählt, daß dieselbe die erforderliche Dünnheit für die Dotierung der Gateelektrode durch eine oberflächennahe Ionenimplantation aufweist.

Wie bereits vorhergehend erwähnt wurde, kann alternativ nur eine einzige Isolationsschicht als Maskenschicht verwendet werden, wobei die Dünnung derselben durch einen anisotropen RIE-Ätzschritt mit einer fest eingestellten Ätzzeit erfolgt.

Bei dem beschriebenen Ausführungsbeispiel wird zur Strukturierungsätzung der leitfähigen Schicht 19 und der hochleitfähigen Schicht 20 der Photolack 25 entfernt. Daraufhin wird die Ätzung der leitfähigen Schicht 19 und der hochleitfähigen Schicht 20 durchgeführt, die die Strukturierung der Gate-Elektrode und des Fensters in dem Bipolarbereich bewirkt.

Dabei wirkt die in dem Gateelektorden-Bereich verbliebenen TEOS-Isolationsschicht 21a und Nitrid-Isolationsschicht 21b als eine Hartmaske, die ein Abtragen der leitfähigen Schicht 19 in dem Gatebereich verhindert. Bei dieser Ätzung wird die Nitrid-Isolationsschicht 21b abgetragen, so daß lediglich die TEOS-Isolationsschicht 21a mit einer Dicke von etwa 20 nm verbleibt, siehe Fig. 18a.

In dem übrigen Bereich des MOS-Bereichs, der bei der Ätzung von keiner Isolationsschicht bedeckt ist, wird die leitfähige Schicht 19 und die erste Gate-Elektrodenschicht 15 durch die Ätzung entfernt, wobei die Ätzung auf der Gate-Dielektrikumsschicht 14 bzw. den Isolationsbereichen 5 stoppt. Ferner wird in dem Bipolarbereich die hochleitfähige Schicht 20 und die Diffusionsschicht 20a entfernt, wobei die Überätzung sehr gering gehalten wird, da in dem Bipolarbereich durch die darunterliegende Epitaxieschicht 4 kein Ätzstopp vorhanden ist. Durch die Dünnung der leitfähigen Schicht 19 in einem vorhergehenden Schritt wird dabei erreicht, daß trotz einer gering gehaltenen Überätzung die Gateelektrodenstruktur im MOS-Bereich ohne Reste an Topographiestufen strukturiert wird.

Mit dem obig beschriebenen Ätzschritt werden folglich drei Funktionen erfüllt.

Als erstes wird durch die TEOS-Isolationsschicht 21a eine Ätzung der leitfähigen Schicht 19 in dem Bereich der Gate-Elektrode verhindert und die Isolationsschicht auf die für die darauffolgende Ionenimplantation der Gate-Elektrode erforderliche Dicke von etwa 10 nm reduziert.

Ferner wird, wie es in Fig. 18a dargestellt ist, die Gate-Elektrode strukturiert.

Der dritte Aspekt umfaßt die Strukturierung eines Fensterbereichs als eine Ausnehmung in der hochleitfähigen Schicht 20, die eine Basisanschlußschicht für den vertikalen NPN-Bipolartransistor darstellt. Der gebildete Fensterbereich dient bei einer späteren Dotierung als Dotierfenster zum Bilden des Basis- und Kollektorbereichs.

Die erfindungsgemäße gleichzeitige Strukturierung des Fensterbereichs und der Gateelektrode spart entsprechende Strukturierungsschritte, wie beispielsweise zusätzliche Photolithographieschritte und Ätzschritte, ein, und liefert ein hohes Maß an Parallelität für das Verfahren.

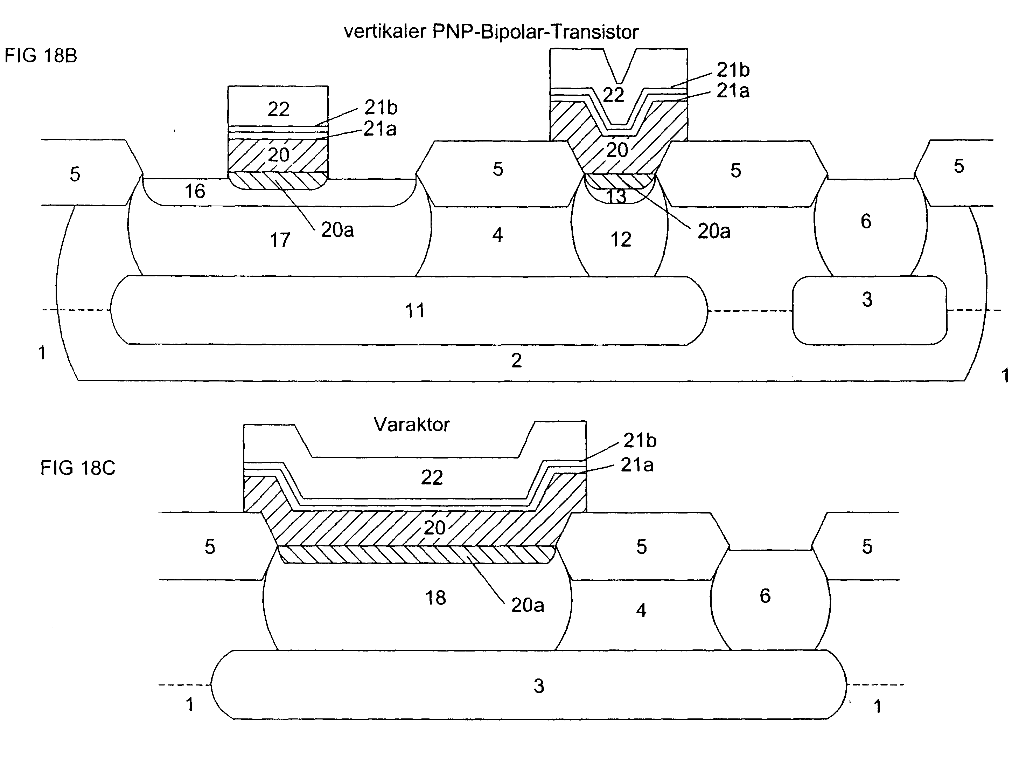

Fig. 18b zeigt den V-PNP-Bereich nach der Durchführung der obig beschriebenen Herstellungsschritte. Eine Diffusionsschicht 20a, die durch Diffusion von Akzeptor-Ionen von einer darüber angeordneten hochleitfähigen Schicht 20 in dem Basisbereich 16 entsteht, ist in einem mittleren Bereich des Basisbereichs 16 ausgebildet. Über der hochleitfähigen Schicht 20 sind die TEOS-Isolationsschicht 21a, die Nitrid-Isolationsschicht 21b und die zweite Isolationsschicht 22 angeordnet. Ferner ist in dem Bereich des Kollektoranschlusses in der Nähe der Oberfläche der leitenden Schicht 13 eine weitere Diffusionsschicht 20a ausgebildet, auf der wiederum die hochleitfähige Schicht 20, die TEOS-Isolationsschicht 21a, die Nitrid-Isolationsschicht 21b und die zweite Isolationsschicht 22 angeordnet ist. Die Diffusionsschicht 20a verbessert den Ohmschen Kontakt der hochleitfähigen Schicht 20 mit der leitenden Schicht 13.

Durch die oben beschriebenen Schritte zum Strukturieren der Gate-Elektrode des MOS-Transistors und zum Strukturieren der Basisanschlußschicht 20 werden somit ferner der Emitteranschlußbereich und der Kollektoranschlußbereich des vertikalen PNP-Transistors strukturiert.

Fig. 18c zeigt den Varaktorbereich in dem Verfahrenszustand, der den Fig. 18a und 18b entspricht. In dem oberflächennahen Bereich der Wanne 18 ist die Diffusionsschicht 20a ausgebildet, auf der die hochleitfähige Schicht 20, die TEOS-Isolationsschicht 21a, die Nitrid-Isolationsschicht 21b und die zweite Isolationsschicht 22 angeordnet sind, wobei sich dieselben über den Bereich der Wanne 18 und jeweils in den Bereich von Isolationsbereichen 5 erstrecken.

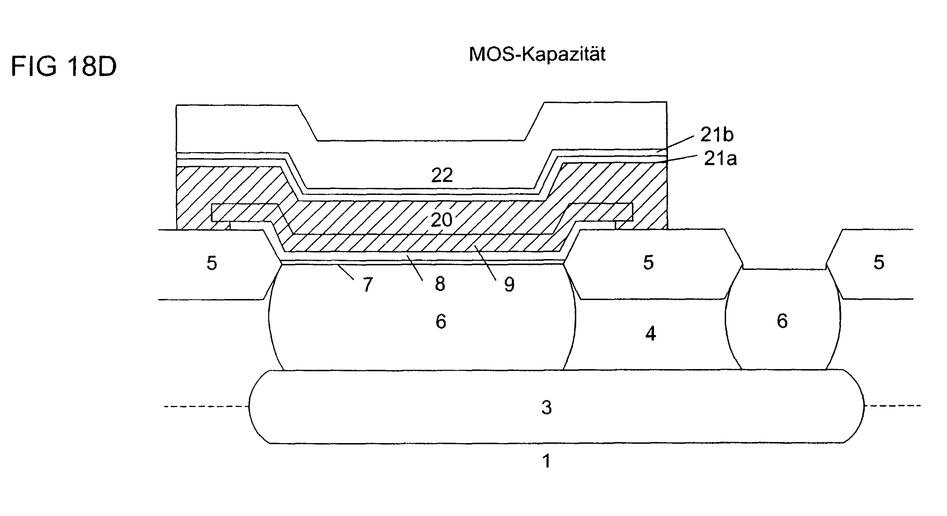

Ferner zeigt Fig. 18d den Kapazitätsbereich in dem Verfahrenszustand, der den Fig. 18a-c entspricht. Über der leitfähigen Schicht 9 ist die hochleitfähige Schicht 20, die TEOS-Isolationsschicht 21a, die Nitrid-Isolationsschicht 21b und die zweite Isolationsschicht 22 angeordnet, wobei sich dieselben über den Bereich der Verbindungswanne 6 in Bereiche der anliegenden Isolationsbereiche 5 erstrecken. Die leitfähige Schicht 9 wird durch die thermische Belastung vorangegangener Temperungen und Schichtabscheidungen durch Dotierstoffdiffusion aus der hochleitfähigen Schicht 20 dotiert.

In einem nächsten Herstellungsschritt wird eine dünne Isolationsschicht 26, die beispielsweise aus einem thermischen Oxid gebildet sein kann, abgeschieden. Die dünne Isolationsschicht 26 erfüllt gleichzeitig mehrere Funktionen, indem sie während der folgenden Implantation ein sogenanntes Channeling des Dotierstoffes in der Epitaxieschicht 4 während der Implantation unterdrückt und ferner eine Diffusion des implantierten Dotierstoffes aus der Epitaxieschicht 4 bei einer nachfolgenden Temperung verhindert.

Darüber hinaus wirkt die Isolationsschicht 26, die sich über die Oberflächenbereiche und die Seitenwandbereiche der ausgebildeten Strukturen erstreckt, für den Gate-Bereich der MOS-Transistoren als eine Isolationsschicht, die den Gate-Bereich umgibt, so daß lediglich geringe Leckströme an der Grenzfläche der Gate-Elektrode 15 zu dem Gate-Dielektrikum zugelassen werden.

Die dünne Isolationsschicht 26 stellt folglich eine nachträglich aufgebrachte Isolationsschicht dar, die auch als ein Post-Oxid bezeichnet wird. Ferner wirkt die dünne Oxidschicht 26 und die Gate-Dielektrikumsschicht als eine Stoppschicht für die folgende anisotrope Ätzung einer Schicht 33 mit hoher n-Dotierung im CMOS-Bereich.

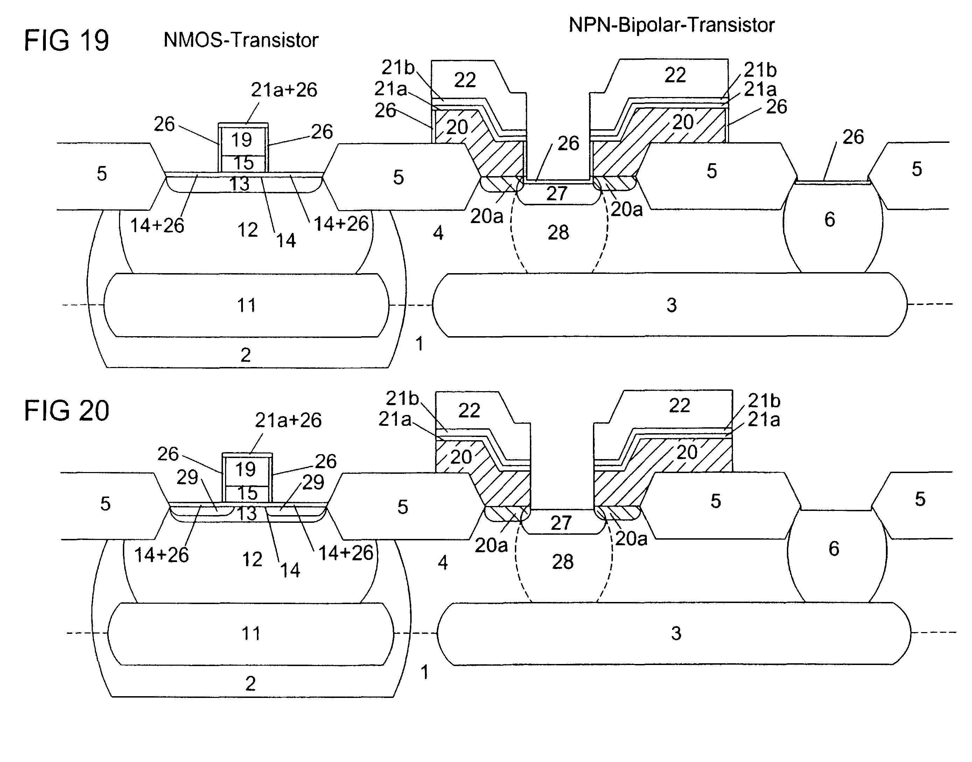

In einem folgenden Schritt wird der NPN-Basisbereich 27 und der NPN-Kollektorbereich 28 erzeugt. Die jeweiligen Dotierstoffe werden über die dünne Isolationsschicht 26, die in dem Fenster des Bipolarbereichs direkt auf der Epitaxieschicht 4 angeordnet ist, implantiert und die Implantationsschäden durch Temperung ausgeheilt. Fig. 19 zeigt den Kollektorbereich 28 als einen wannenförmigen Bereich, der mit der vergrabenen Schicht 3 verbunden ist. Ferner ist zwischen dem NPN-Kollektorbereich 28 und der dünnen Isolationsschicht 26 in dem Bereich des Fensters des Bipolarbereichs der p-dotierte NPN-Basisbereich ausgebildet.

In einem nächsten Verfahrensschritt wird die dünne Isolationsschicht 26 in dem Bipolar-Bereich entfernt, da in dem Bereich des Fensters in dem Bipolar-Bereich ein Emitterbereich gebildet wird, der einen direkten Kontakt zu dem NPN-Basisbereich 27 benötigt.

Bei einem weiteren alternativen Ausführungsbeispiel wird die dünne Isolationsschicht 26 sowohl in dem Bipolar-Bereich als auch in dem MOS-Bereich entfernt.

Die bei dem beschriebenen Ausführungsbeispiel in dem MOS-Bereich verbleibende dünne Isolationsschicht 26 dient bei den folgenden Dotierstoffimplantationen für die Gate-Elektrode und den Source- und Drain-Bereich als eine Streuschicht. Darüber hinaus dient die dünne Isolationsschicht 26 in dem MOS-Bereich ferner als Stopp-Schicht für noch folgende Ätzungen.

In einem ersten Dotierungsschritt werden daraufhin LDD-Gebiete (Lightly-Doped-Drain-Gebiete = Leicht-Dotierungs-Drain-Gebiete) für die MOS-Transistoren durch eine Implantation und eine darauffolgende Temperung erzeugt.

Fig. 20 zeigt in dem MOS-Bereich die LDD-Bereiche 29 des Source- bzw. Drain-Bereichs des MOS-Transistors, die sich nahe der Oberfläche unterhalb der Gate-Dielektrikumsschicht erstrecken und voneinander beabstandet sind, um in einem Bereich unterhalb der ausgebildeten Gate-Elektrode die Bildung eines Inversionskanals in der leitenden Schicht 13 zu ermöglichen. In dem Fall, daß außer dem beschriebenen NMOS-Transistor auch ein PMOS-Transistor hergestellt wird, wird der Dotierstoff für die p-dotierten LDD-Bereiche des PMOS-Transistors implantiert.

Anschließend wird eine Abstandhalterschicht, die mindestens eine Schicht umfaßt, ganzflächig aufgebracht. Sie bedeckt die während des Herstellungsprozesses gebildete Seitenwände, die die Seitenwände der Gate-Elektrode, des Fensters im Bipolarbereich und des Emitter-Anschluß des V-PNP-Transistors umfassen.

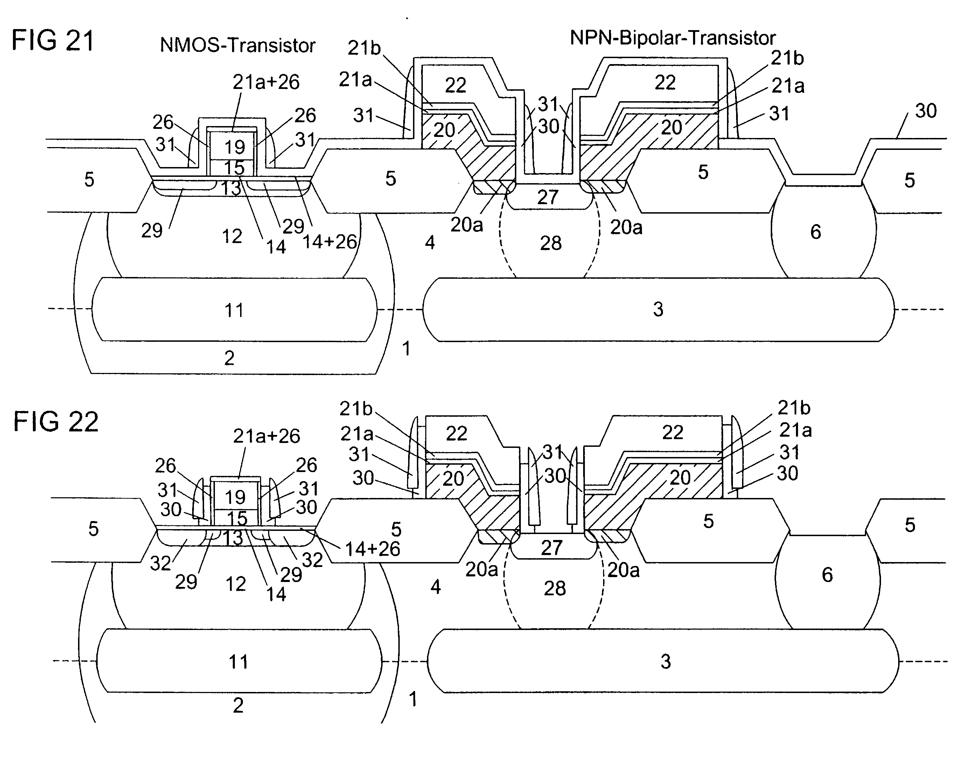

Bei dem beschriebenen Ausführungsbeispiel umfaßt die Abstandhalterschicht eine erste Abstandhalterschicht 30 und eine zweite Abstandhalterschicht 31, wie in Fig. 21 gezeigt ist.

Die Gesamtdicke der als Abstandhalterschicht dienenden Isolationsschicht bzw. Isolationsschichten wird dabei so gewählt, daß ein nachfolgend aus den Schichten gebildeter Abstandhalter in dem MOS-Bereich lateral so weit von den LDD-Gebieten entfernt ist, daß bei einem darauffolgenden Dotierungsschritt der Source-/Drain-Gebiete 32 und den darauffolgenden Diffusionsschritten die LDD-Bereiche 29 nicht überdeckt werden.

Die Source-/Drain-Gebiete 32 stellen dabei HDD-Gebiete (Highly-Doped-Drain-Gebiete; Hoch-Dotierungs-Drain-Gebiete) dar, wobei die Verwendung von LDD-Gebieten und HDD-Gebieten sogenannte Heiße-Elektronen-Effekte verhindert, die zu einer Verringerung des Sättigungsdrainstroms führen können.

Ferner ist die Dicke der als Abstandhalterschicht dienenden Isolationsschichten im Bipolar-Bereich so gewählt, daß der noch zu bildende Emitter und die Basisanschlüsse des NPN-Transistors ausreichend weit entfernt sind, um einen Diodenleckstrom zwischen den beiden Bereichen zu verhindern. Bei dem Ausführungsbeispiel werden die erste Abstandhalterschicht 30 und die zweite Abstandhalterschicht 31 konform abgeschieden, wobei die zweite Abstandhalterschicht 31 in einem anisotropen RIE-Schritt so lange rückgeätzt wird, bis dieselbe an den Seitenwänden von Topographiestufen übrigbleibt. Die erste Abstandhalterschicht 30 dient als eine Stoppschicht für die Ätzung, um eine Schädigung der Epitaxieschicht 4 zu vermeiden.

Ein Vorteil der Verwendung der Abstandhalterschicht 30 besteht darin, daß dieselbe in dem Bipolarbereich zusätzlich zur Isolierung zwischen einem Basisanschluß und dem Emitter verwendet wird, wie es nachfolgend erklärt wird. Dadurch erhöht sich wiederum die Parallelität des Verfahrens, wobei durch die eingesparte Aufbringung einer oder mehrerer Schichten eine thermische Belastung der Bauelemente im Vergleich zu bekannten Verfahren veringert wird.

Fig. 21 zeigt den MOS-Bereich und den Bipolar-Bereich nach der Durchführung der Rückätzung der zweiten Abstandhalterschicht 31. Die erste Abstandhalterschicht 30 erstreckt sich ganzflächig über den MOS-Bereich und den Bipolar-Bereich und über die Seitenwände von Topographiestufen. Die zweite Abstandhalterschicht 31 ist an den Seitenwänden von Topographiestufen, d.h. an den Seitenwänden der Gate-Elektrode, des Fensters und der Topographiestufe der Schichten 20, 21a, 21b und 22, auf der ersten Abstandhalterschicht gebildet.

In einem nächsten Schritt wird die erste Abstandhalterschicht 30 bis auf eine Restdicke von etwa 10 nm selektiv zu der zweiten Abstandhalterschicht 31 gedünnt.

Fig. 22 zeigt den MOS-Bereich und den Bipolar-Bereich nach der Durchführung dieses Herstellungsschrittes. Die seitlich an der Gate-Elektrode angeordnete Schichtenfolge aus der ersten Abstandhalterschicht 30 und der zweiten Abstandhalterschicht 31 wirkt bei dem folgenden Dotierschritt als eine Abstandhalterbarriere, um eine vollständige Überdeckung der LDD-Bereiche 29 durch die HDD-Bereiche 32 zu verhindern.

Danach werden die HDD-Bereiche 32 durch eine Implantation und eine darauffolgende Temperung gebildet. Durch die Temperung wird der Dotierstoff der NPN-Basis so weit in das Substrat diffundiert, daß der bei einem späteren Schritt von der Substratoberfläche eindiffundierte Emitter die Basis nicht überdeckt.

In dem Fall, daß außer dem beschriebenen NMOS-Transistor auch ein PMOS-Transistor hergestellt wird, wird der Dotierstoff für die p-dotierten Source-/Drain-Bereiche des PMOS-Transistors implantiert.

Ein wesentlicher Vorteil des Verfahrens besteht darin, daß die Dotierung der Source-, Drain- und Gatebereiche des MOS-Transistors nach einer Dotierung der Kollektor- und Basis-Bereiche des Bipolartransistors stattfindet. Im Falle einer Dotierung der Source-, Drain- und Gatebereiche vor dem Dotieren der Kollektor- und Basis-Bereiche wird durch die zusätzlichen Temperaturbelastungen ein gezieltes Einstellen von Dotierstoffverteilungen, die typischerweise Bor umfassen, erschwert bzw. behindert, was zu einer Verschlechterung des MOS-Transistors führt. Durch die Vermeidung dieses nachteiligen Effekts kann das Verfahren auch zur Herstellung von Bauteilen mit hoher Temperaturempfindlichkeit eingesetzt werden, wie es beispielsweise bei der 0,25µm-CMOS-Technologie der Fall ist.

Daraufhin wird die erste Abstandhalterschicht 30 ganzflächig selektiv zu der zweiten Abstandhalterschicht 31 so weit gedünnt, bis die dünne Isolationsschicht 26, die im Bipolar-Bereich schon vorher entfernt wurde, im MOS-Bereich freigelegt ist.

Aufgrund der Dünnung der ersten Abstandhalterschicht 30 auf eine Restdicke von etwa 10 nm liegt nach der Durchführung dieses Ätzschrittes in dem Bipolarbereich die Epitaxieschicht 4 frei.

Alternativ kann bei einem Ausführungsbeispiel die Ätzung der restlichen ersten Abstandhalterschicht 30 durch eine Photolackmaske auf den Bipolar-Bereich beschränkt werden, um die dünne Isolationsschicht 26 und die gedünnte erste Abstandhalterschicht 30 in dem MOS-Bereich als eine Stoppschicht für die folgende Ätzung einer noch aufzubringenden Polysiliziumschicht zu erhalten.

Bei dem vorhergehend beschriebenen weiteren alternativen Ausführungsbeispiel, bei dem die dünne Isolationsschicht 26 sowohl in dem Bipolar-Bereich als auch in dem MOS-Bereich entfernt wurde, darf die restliche erste Abstandhalterschicht 30 lediglich im Bipolar-Bereich entfernt werden, da ansonsten in dem MOS-Bereich die Stoppschicht für die Ätzung der noch aufzubringenden Anschlußschicht 33 aus Polysilizium fehlt.

In einem weiteren Schritt wird der an den Seitenwänden ausgebildete Abstandhalter aus der zweiten Abstandhalterschicht 31 selektiv zu der ersten Abstandhalterschicht 30 und dem Substratmaterial entfernt.

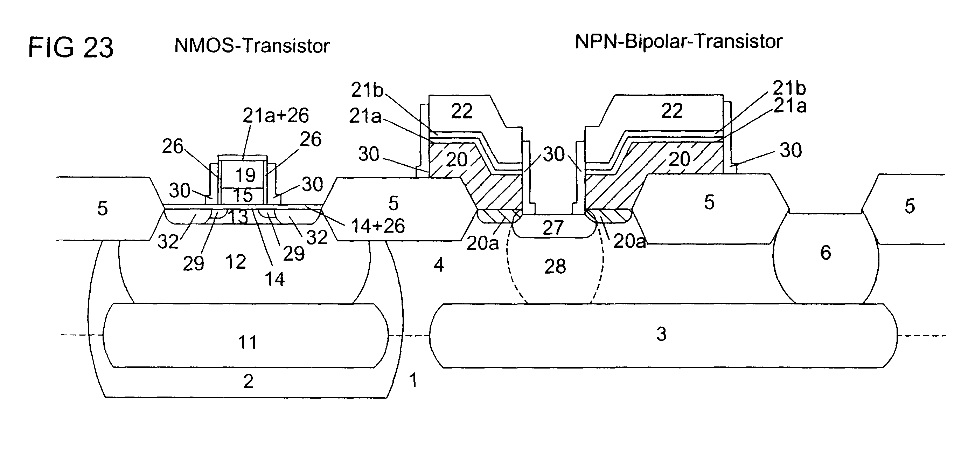

Fig. 23 zeigt den MOS-Bereich und den Bipolar-Bereich nach der Durchführung der obig beschriebenen Schritte. Gemäß Fig. 23 ist die erste Abstandhalterschicht 30 an den Seitenwänden der Gate-Elektrode, des Fensters in dem Bipolar-Bereich und der Topographiestufe, die durch die Schichten 20, 21a, 21b und 22 gebildet wird, ausgebildet.

In einem nächsten Schritt wird eine Anschlußschicht 33 aus Polysilizium mit einer hohen n-Dotierung ganzflächig abgeschieden und strukturiert. Die Anschlußschicht 33 aus Polysilizium dient in dem Bipolar-Bereich als Emitter und Kollektoranschluß, in dem V-PNP-Bereich als ein Basisanschluß und in dem Kapazitätsbereich bzw. dem Varaktorbereich als ein Anschluß für die untere Elektrode. Die dünne Isolationsschicht 26 wird in dem MOS-Bereich als ein Ätzstopp zum Substrat verwendet.

Bei dem alternativen Ausführungsbeispiel, bei dem in dem MOS-Bereich die gedünnte erste Abstandhalterschicht 30 vorhanden ist, bilden die dünne Isolationsschicht 26 und die gedünnte erste Abstandhalterschicht 30 den Ätzstopp. Die darauffolgende Ätzung der Anschlußschicht 33 aus Polysilizium erfolgt mit einer Photolackmaske.

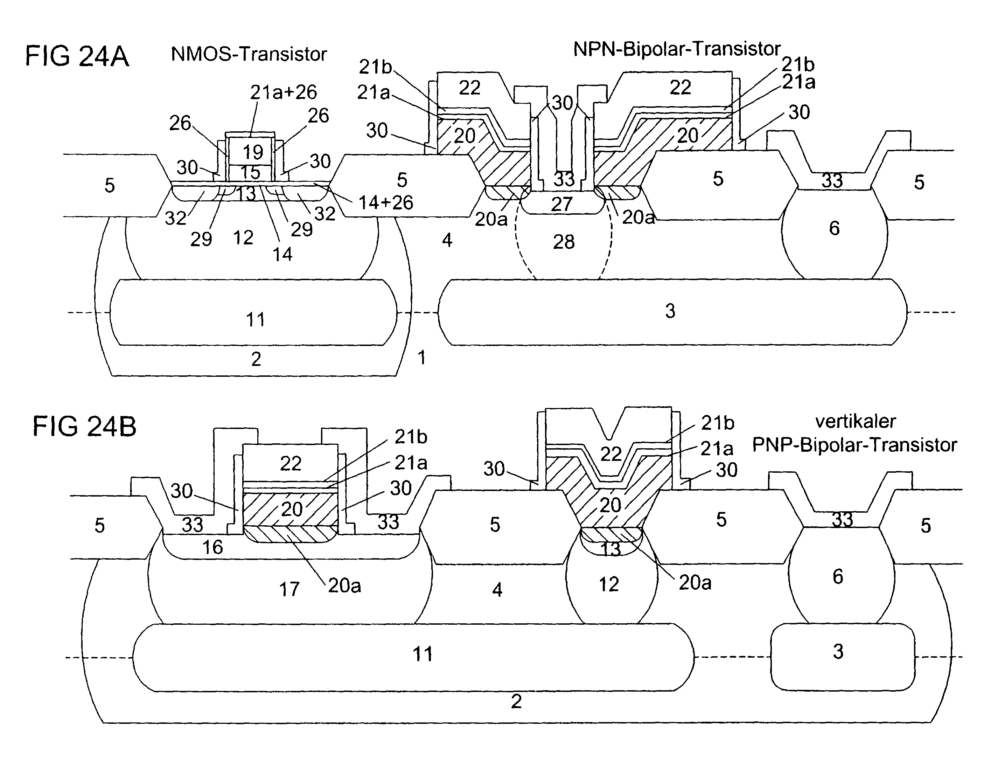

Fig. 24a zeigt den MOS-Bereich und den Bipolar-Bereich nach Vollendung der Abscheidung und Ätzung der Anschlußschicht 33 aus Polysilizium. Die n-dotierte Anschlußschicht 33 aus Polysilizium erstreckt sich in vertikaler Richtung im wesentlichen entlang der ersten Abstandhalterschicht 30, die an den Seitenwänden des Fensters in dem Bipolar-Bereich angeordnet ist und ferner entlang der Oberfläche des NPN-Basisbereichs 27. Wie es in der Figur zu erkennen ist, liefert die seitlich angeordnete erste Abstandhalterschicht 30 eine elektrische Isolierung der Anschlußschicht 33 aus Polysilizium, die einen Emitteranschluß darstellt, zu der hochleitfähigen Schicht 20, die einen Basisanschluß darstellt.

Fig. 24b zeigt den V-PNP-Bereich in dem Verfahrenszustand der Fig. 24a. Die Anschlußschicht 33 aus Polysilizium liefert für den V-PNP-Transistor einen Anschluß für den Basisbereich 16. Die n-dotierte Anschlußschicht 33 aus Polysilizium erstreckt sich im wesentlichen entlang der seitlich angeordneten Abstandhalterschicht 30 und über die Oberfläche des Basisbereichs 16 und teilweise in den Bereich der angrenzenden Isolationsbereiche 5. Wie in Fig. 24a liefert auch in Fig. 24b die erste Abstandhalterschicht 30 eine elektrische Isolierung, in diesem Fall zwischen der als Basisanschluß wirkenden Anschlußschicht 33 aus Polysilizium und der hochleitenden Schicht 20, die einen Emitteranschluß darstellt. Ferner ist die Anschlußschicht 33 aus Polysilizium auf der Oberfläche der Verbindungswanne 6 gebildet, um einen Substratkontakt für den V-PNP-Bipolartransistor zu liefern.

Die gleichzeitige Verwendung der Abstandhalterschicht 30 als Abstandhalter zur Dotierung der Drain- und Sourcebereiche sowie als Seitenwandisolierung des Basisanschlußes ergibt den Vorteil, daß das Aufbringen zusätzlicher Schichten eingespart wird, wodurch sich einerseits die Parallelität des Verfahrens erhöht und andererseits Abdeckschichten über den MOS- und Bipolartransistoren nicht aufgebracht werden müssen, die bei einer sukzessiven Prozessierung der MOS- und Bipolarbauteile zum Schützen der Bauteile mit einer Schichtdicke aufgebracht werden müssen, die eine Dichtheit bei einer naßchemischen Ätzung garantiert.

Wie es aus der vorhergehenden Beschreibung und den Figuren zu erkennen ist, wird die Topologie zwischen dem Bipolar-Bereich und dem MOS-Bereich bis zum Abschluß von anisotropen Ätzschritten so gering gehalten, daß eine Entfernung von parasitären Abstandhaltern nicht erforderlich ist.

Ferner wird durch das Verfahren die Bildung eines Randes mit einer Breite von einigen µm zwischen MOS- und Bipolarteilen vermieden, was einen weiteren Vorteil der Erfindung gegenüber bekannten Verfahren darstellt und eine Flächenreduktion von Produkten ermöglicht.

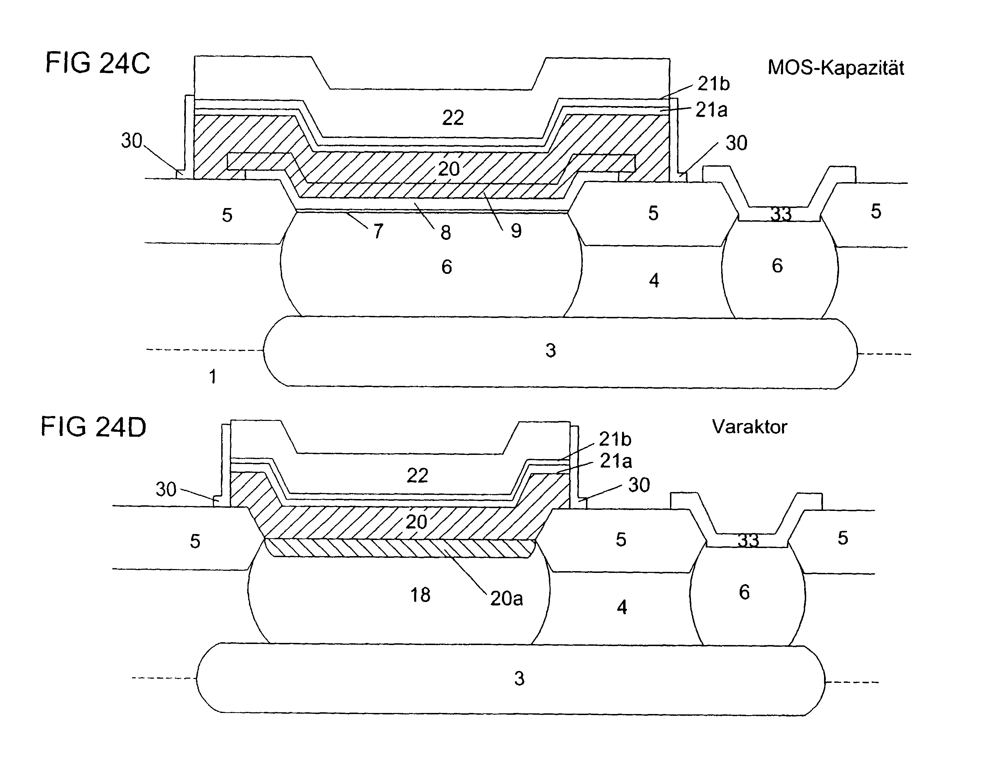

Fig. 24c zeigt den Kapazitätsbereich in dem gleichen Verfahrenszustand der Fig. 24a und 24b. Die Anschlußschicht 33 aus Polysilizium ist auf der Oberfläche der Verbindungswanne 6 gebildet, die über die vergrabene Schicht 3 einen Anschluß an die untere Elektrode der MOS-Kapazität liefert.

Fig. 24d zeigt den Varaktorbereich ebenfalls in dem Herstellungszustand der Fig. 24a-c. Die Anschlußschicht 33 aus Polysilizium ist auf der Verbindungswanne 6 gebildet und liefert über die Verbindungswanne 6 und die vergrabene Schicht 3 einen Anschluß an die n-dotierte Wanne 18.

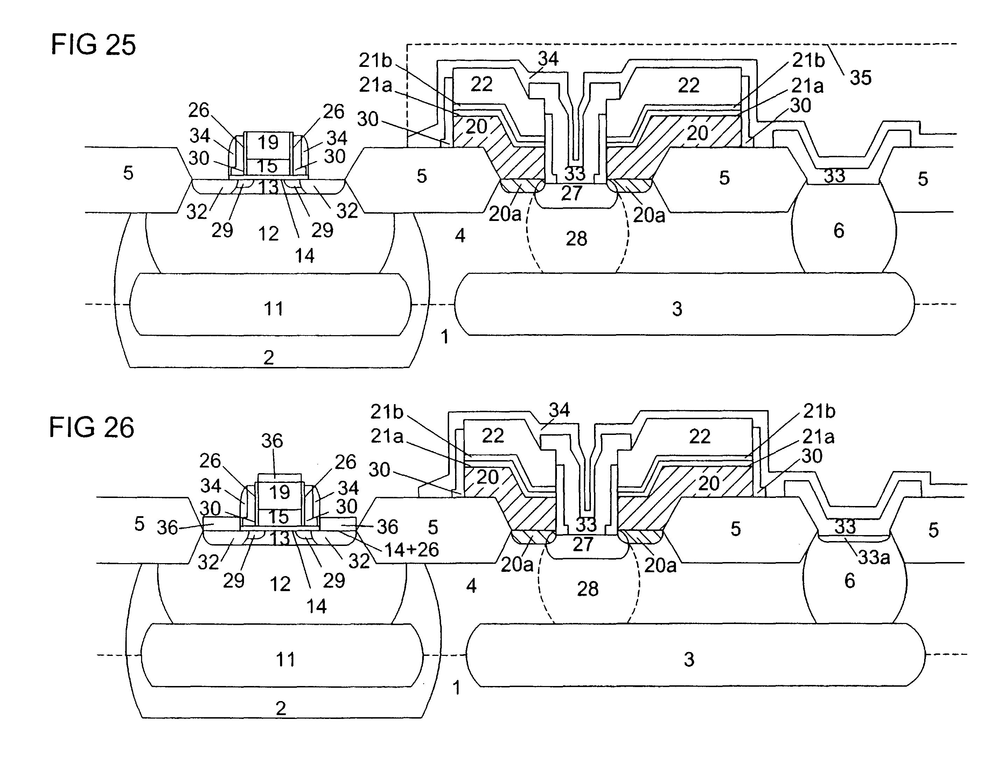

Um leitende Schichten niederohmiger zu machen werden dieselben bei einem folgenden Verfahrensschritt mit einer Silizid-Schicht bedeckt. Dazu wird eine Schutzschicht 34 abgeschieden und mittels einer Photolackmaske 35 strukturiert, wie es in Fig. 25 gezeigt ist. Daraufhin wird die Photolackmaske 35 entfernt. Um das Schrumpfen der Schutzschicht 34 während der Silizidbildung zu verhindern, was zu einem Ablösen der Silizidschicht von der Schutzschicht 34 führen würde, kann eine Temperung eingesetzt werden. Während dieser oder einer nachfolgenden Temperung diffundiert der Dotierstoff einige 10 nm tief aus der hoch n-dotierten Anschlußschicht 33 aus Polysilizium in das darunterliegende Substrat und bildet durch die Emitterdiffusionsschicht 33a eine niederohmige Verbindung zu allen n-dotierten Kontakten, wie beispielsweise dem BasisAnschluß des V-PNP-Transistors, dem Anschluß der unteren Elektrode der MOS-Kapazität und der Kathode des Varaktors. In einem anschließenden Abscheidungsprozeß wird die Silizidschicht 36 gebildet.

Fig. 26 zeigt den MOS-Bereich und den Bipolar-Bereich nach Vollendung der Silizidaufbringung, die gleichzeitig den letzten Schritt bei der Herstellung des MOS-Transistors und des Bipolar-Transistors darstellt. Gemäß Fig. 26 weist der fertig prozessierte MOS-Transistor auf den HDD-Bereichen der Sourceund Drainbereiche die Silizidschicht 36 auf. Für die Abscheidung der Silizidschicht 36 auf den Source- bzw. Drain-Bereichen bilden die seitlich angeordnete Abstandhalterschicht 26 und die darüber angeordnete Schutzschicht 34 einen Abstandhalter. Ferner ist die Silizidschicht 36 auf der leitfähigen Schicht 19 der Gate-Elektrode gebildet. Insbesondere weisen der MOS-Transistor und der Bipolartransistor außer der Schutzschicht 34 keine zusätzlichen Abdeckschichten auf, die zu einer hohen mechanischen Belastung und einer Verschlechterung empfindlicher Bauteile führen würde.

### Bezugszeichenliste

- 1: Substrat
- 2: Wannenbereich
- 3: vergrabene Schicht
- 4: Epitaxieschicht
- 5: Isolationsbereich
- 6: Verbindungswanne
- 7: Oxidschicht
- 8: Nitridschicht
- 9: leitfähige Elektrodenschicht
- 10: Photolackmaske
- 11: Anschlußschicht
- 12: Wanne
- 13: leitende Schicht
- 14: Gate-Dielektrikumsschicht
- 15: erste Gate-Elektrodenschicht
- 16: Basisbereich
- 17: Kollektorbereich
- 18: Wanne
- 19: leitfähige Schicht
- 20: hochleitfähige Schicht
- 20a: Diffusionsschicht
- 21a: TEOS-Isolationsschicht
- 21b: Nitrid-Isolationsschicht
- 22: zweite Isolationsschicht
- 23a: ARC-Schicht
- 23b: ARC-Schicht
- 24: Photolack
- 25: Photolack
- 26: Isolationsschicht
- 27: NPN-Basisbereich
- 28: NPN-Kollektorbereich
- 29: LDD-Bereich
- 30: erste Abstandhalterschicht
- 31: zweite Abstandhalterschicht
- 32: HDD-Bereich
- 33: Anschlußschicht
- 33a: Diffusionsbereich
- 34: Schutzschicht
- 35: Photolackmaske
- 36: Silizidschicht

## Patentansprüche

1. Verfahren zum parallelen Herstellen eines MOS-Transistors in einem MOS-Bereich eines Substrats (1) und eines Bipolar-Transistors in einem Bipolar-Bereich des Substrats (1), mit folgenden Schritten:
a) Erzeugen einer MOS-Vorbereitungsstruktur in dem MOS-Bereich, wobei die MOS-Vorbereitungsstruktur einen für einen Kanal vorgesehenen Bereich (13), ein Gatedielektrikum (14), eine Gate-Elektrodenschicht (15, 19) und eine Maskenschicht(21a, 21b, 22) auf der Gate-Elektrodenschicht (15, 19) umfaßt;
b) Erzeugen einer Bipolar-Vorbereitungsstruktur in dem Bipolar-Bereich, wobei die Bipolar-Vorbereitungsstruktur eine leitfähige Schicht (20) und eine Maskenschicht (21a, 21b, 22) auf der leitfähigen Schicht (20) umfaßt;
c) gemeinsames Strukturieren der Gate-Elektrodenschicht (15, 19) und der leitfähigen Schicht (20) unter Verwendung der Maskenschichten (21a, 21b, 22) zur Festlegung einer Gate-Elektrode im MOS-Bereich und eines Basisanschlußbereichs und/oder Emitter/Kollektoranschlußbereichs im Bipolar-Bereich;
d) gleichzeitiges Erzeugen von isolierenden Abstandhalterschichten (30, 31) auf Seitenwänden der Gate-Elektrodenschicht im MOS-Bereich und der leitfähigen Schicht im Bipolar-Bereich durch Aufbringen einer ersten (30) und zweiten Abstandhalterschicht (31), wobei die isolierenden Abstandhalterschichten im MOS-Bereich zur Definition von zu dotierenden Bereichen dienen und die erste Abstandhalterschicht (30) im Bipolarbereich zur Isolation eines Basisbereichs und eines Emitterbereichs dient;
e) selektives Ätzen der ersten Abstandhalterschicht (30) und der zweiten Abstandhalterschicht (31) in dem MOS-Bereich und Bipolarbereich; und
f) Entfernen der zweiten Abstandhalterschicht (31) im MOS-Bereich und Bipolarbereich.

2. Verfahren nach Anspruch 1, bei dem die Maskenschicht (21a, 21b, 22) im MOS-Bereich und die Maskenschicht (21a, 21b, 22) im Bipolarbereich durch gemeinsames Aufbringen zumindest einer Isolationsschicht erzeugt wird.

3. Verfahren nach Anspruch 2, das ferner den Schritt des Strukturierens der Maskenschicht (21, 21b, 22) im MOS-Bereich zum Definieren der Gate-Elektrode und im Bipolar-Bereich zum Definieren des Basisanschlußbereichs und/oder Kollektoranschlußbereichs aufweist.

4. Verfahren nach Anspruch 3, das ferner den Schritt des Dünnens der Maskenschicht (21a, 21b, 22) im Bereich der Gate-Elektrode aufweist.

5. Verfahren nach Anspruch 4, bei dem die Maskenschicht eine erste (21a, 21b) und eine zweite (22) Isolationsschicht aufweist.

6. Verfahren nach einem der Ansprüche 1 bis 5, das ferner einen Schritt des gemeinsamen Aufbringens der leitfähigen Schicht (20) im Bipolar-Bereich und zumindest eines Teils (19) der Gateelektrodenschicht im MOS-Bereich aufweist.

7. Verfahren nach Anspruch 6, bei dem die Gateelektrodenschicht eine erste (15) und zweite Gate-Elektrodenteilschicht (19) aufweist, wobei die zweite Gate-Elektrodenteilschicht (19) zusammen mit der leitfähigen Schicht (20) im Bipolarbereich aufgebracht wird.

8. Verfahren nach einem der Ansprüche 1 bis 7, bei dem vor dem gemeinsamen Strukturieren ein Dünnen der Gate-Elektrodenschicht (15, 19) durchgeführt wird.

9. Verfahren nach einem der Ansprüche 1 bis 8, bei dem im Schritt c) im Bipolar-Bereich aus der leitfähigen Schicht (20) ein Basisanschlußbereich und ein in demselben angeordnetes Fenster zum Dotieren eines Kollektorbereichs (28) und/oder eines Basisbereichs (27) strukturiert wird.

10. Verfahren nach einem der Ansprüche 1 bis 8, bei dem im Schritt c) im Bipolarbereich aus der leitfähigen Schicht (20) ein Kollektoranschlußbereich und ein Emitteranschlußbereich strukturiert wird.

11. Verfahren nach einem der Ansprüche 1 bis 10, bei dem auf der Maskenschicht(21a, 21b, 22) eine Antireflexionsschicht (23a, 23b) erzeugt wird.

12. Verfahren nach einem der Ansprüche 1 bis 11, das ferner nach dem Schritt c) ein Dotieren eines Kollektorbereichs (28) und/oder eines Basisbereichs (27) in dem Bipolar-Bereich umfaßt, und ein gemeinsames Dotieren eines Source-Bereichs (32) und/oder Drainbereichs (32) in dem Kanalbereich (13) und der Gate-Elektrode umfaßt.

13. Verfahren nach einem der Ansprüche 1 bis 12, bei dem der Schritt c) ferner ein gleichzeitiges Ätzen der Gateelektrodenschicht (15, 19) und der leitfähigen Schicht (20) umfaßt.

14. Verfahren nach einem der Ansprüche 1 bis 13, das ferner ein paralleles Erzeugen eines oder mehrerer Bauelemente aus der Gruppe aufweist, die eine Varaktor-Diode und einen MOS-Kondensator umfaßt.

## Claims

1. Method for manufacturing a MOS transistor in a MOS region of a substrate (1) and a bipolar transistor in a bipolar region of the substrate (1) in parallel, comprising the following steps:
a) generating a MOS preparation structure in the MOS region, wherein the MOS preparation structure includes a region (13) intended for a channel, a gate dielectric (14), a gate electrode layer (15, 19), and a mask layer (21a, 21b, 22) on the gate electrode layer (15, 19);
b) generating a bipolar preparation structure in the bipolar region, wherein the bipolar preparation structure includes a conductive layer (20) and a mask layer (21a, 21b, 22) on the conductive layer (20);
c) structuring the gate electrode layer (15, 19) and the conductive layer (20) together using the mask layers (21a, 21b, 22) for establishing a gate electrode in the MOS region and a base terminal region and/or emitter/collector terminal region in the bipolar region;
d) simultaneously generating isolating spacer layers (30, 31) on side walls of the gate electrode layer in the MOS region and the conductive layer in the bipolar region by applying a first (30) and a second spacer layer (31), wherein the isolating spacer layers in the MOS region serve for defining regions to be doped, and the first spacer layer (30) in the bipolar region serves for isolating a base region and an emitter region;
e) selectively etching the first spacer layer (30) and the second spacer layer (31) in the MOS region and bipolar region; and
f) removing the second spacer layer (31) in the MOS region and bipolar region.

2. Method of claim 1, wherein the mask layer (21a, 21b, 22) in the MOS region and the mask layer (21a, 21b, 22) in the bipolar region is generated by common application of at least one isolation layer.

3. Method of claim 2, further comprising the step of structuring the mask layer (21a, 21b, 22) in the MOS region for defining the gate electrode and in the bipolar region for defining the base terminal region and/or collector terminal region.

4. Method of claim 3, further comprising the step of thinning the mask layer (21a, 21b, 22) in the region of the gate electrode.

5. Method of claim 4, wherein the mask layer comprises a first (21a, 21b) and a second (22) isolation layer.

6. Method according to one of claims 1 to 5, further comprising a step of applying the conductive layer (20) in the bipolar region and at least part (19) of the gate electrode layer in the MOS region together.

7. Method of claim 6, wherein the gate electrode layer comprises a first (15) and a second gate electrode partial layer (19), wherein the second gate electrode partial layer (19) is applied together with the conductive layer (20) in the bipolar region.

8. Method according to one of claims 1 to 7, wherein, prior to common structuring, a thinning of the gate electrode layer (15, 19) is performed.

9. Method according to one of claims 1 to 8, wherein, in step c), a base terminal region and a window located therein for doping a collector region (28) and/or a base region (27) are structured from the conductive layer (20) in the bipolar region.

10. Method according to one of claims 1 to 8, wherein, in step c), a collector terminal region and an emitter terminal region are structured from the conductive layer (20) in the bipolar region.

11. Method according to one of claims 1 to 10, wherein an anti-reflection layer (23a, 23b) is generated on the mask layer (21a, 21b, 22).

12. Method according to one of claims 1 to 11, further including, after step c), doping a collector region (28) and/or a base region (27) in the bipolar region, and including common doping of a source region (32) and/or drain region (32) in the channel region (13) and the gate electrode.

13. Method according to one of claims 1 to 12, wherein step c) further includes simultaneously etching the gate electrode layer (15, 19) and the conductive layer (20).

14. Method according to one of claims 1 to 13, further comprising generating one or more devices from the group including a varactor diode and a MOS capacitor in parallel.

## Revendications

1. Procédé de fabrication parallèle d'un transistor MOS dans une zone MOS d'un substrat (1) et d'un transistor bipolaire dans une zone bipolaire du substrat (1), comprenant les stades suivants :
a) production d'une structure de prétraitement MOS dans la zone MOS, la structure de prétraitement MOS comprenant une zone (13) prévue pour un canal, un diélectrique (14) de grille, une couche (15, 19) d'électrode de grille et une couche (21 a, 21 b, 22) de masque sur la couche (15, 19) d'électrode de grille;
b) production d'une structure de prétraitement bipolaire dans la zone bipolaire, la structure de prétraitement bipolaire comprenant une couche (20) conductrice et une couche (21 a, 21 b, 22) de masque sur la couche (20) conductrice;
c) structuration en commun de la couche (15, 19) d'électrode de grille et de la couche (20) conductrice en utilisant les couches (21 a, 21 b, 22) de masque pour fixer une électrode de grille dans la zone MOS et une zone de borne de base et/ou une zone de borne d'émetteur/connecteur dans la zone bipolaire;
d) production simultanée de couches (30, 31) isolantes d'espaceur sur des parois latérales de la zone de MOS et de la couche conductrice dans la zone bipolaire, par dépôt d'une première couche (30) et d'une deuxième couche (31) d'espaceur, les couches isolantes d'espaceur servant dans la zone MOS à la définition de zone à doper et la première couche (30) d'espaceur servant dans la zone bipolaire à l'isolation d'une zone de base et d'une zone d'émetteur;
e) attaque sélective de la première couche (30) d'espaceur et de la deuxième couche (31) d'espaceur dans la zone MOS et dans la zone bipolaire;
f) élimination de la deuxième couche (31) d'espaceur dans la zone MOS et dans la zone bipolaire.

2. Procédé suivant la revendication 1, dans lequel on produit la couche (21 a, 21 b, 22) de masque dans la zone MOS et la couche (21 a, 21 b, 22) de masque dans la zone bipolaire par dépôt en commun d'au moins une couche isolante.

3. Procédé suivant la revendication 2, qui comporte en outre le stade de la structuration de la couche (21 a, 21 b, 22) de masque dans la zone MOS pour la définition de l'électrode de grille et dans la zone bipolaire pour la définition de la zone de borne de base et/ou de la zone de borne de connecteur.

4. Procédé suivant la revendication 3, qui comporte en outre le stade d'amincissement de la couche (21 a, 21 b, 22) de masque dans la zone de l'électrode de grille.

5. Procédé suivant la revendication 4, dans lequel la couche de masque a une première couche (21 a, 21 b) et une deuxième couche (22) isolante.

6. Procédé suivant l'une des revendications 1 à 5, qui comporte en outre un stade de dépôt en commun de la couche (20) conductrice dans la zone bipolaire et d'au moins une partie (19) de la couche d'électrode de grille dans la zone de MOS.

7. Procédé suivant la revendication 6, dans lequel la couche d'électrode de grille comporte une première sous-couche (15) et une deuxième sous-couche (19) d'électrode de grille, la deuxième sous-couche (19) d'électrode de grille étant déposée ensemble avec la couche (20) conductrice dans la zone bipolaire.

8. Procédé suivant l'une des revendications 1 à 7, dans lequel on effectue un amincissement de la couche (15, 19) d'électrode de grille avant la structuration en commun.

9. Procédé suivant l'une des revendications 1 à 8, dans lequel au stade c) on structure? dans la zone bipolaire constituée de la couche (20) conductrice, une zone de borne de base et une fenêtre disposée dans celle-ci pour le dopage d'une zone (28) de connecteur et/ou d'une zone (27) de base.

10. Procédé suivant l'une des revendications 1 à 8, dans lequel au stade c) on structure, dans la zone bipolaire constituée de la couche (20) conductrice, une zone de borne de connecteur et une zone de borne d'émetteur.

11. Procédé suivant l'une des revendications 1 à 10, dans lequel on produit sur la couche (21 a, 21 b, 22) de masque, une couche (23, 23b) antireflet.

12. Procédé suivant l'une des revendications 1 à 11, qui comprend en outre après le stade c), un dopage d'une zone (28) de connecteur et/ou d'une zone (27) de base dans la zone bipolaire et un dopage en commun d'une zone (32) de source et/ou d'une zone (32) drain dans la zone (13) de canal et sur l'électrode de grille.

13. Procédé suivant l'une des revendications 1 à 12, dans lequel le stade c) comprend en outre une attaque simultanée de la couche (15, 19) d'électrode de grille et de la couche (20) conductrice.

14. Procédé suivant l'une des revendications 1 à 13, qui comprend en outre une production parallèle d'un ou de plusieurs composants choisis dans le groupe qui comprend une diode varactor et un condensateur MOS.
